# EUROPEAN PATENT SPECIFICATION

(11) **EP 4 604 687 B1**
(45) Date of publication and mention of the grant of the patent: **30.09.2026**
(21) Application number: 24197284.3
(22) Date of filing: 29.08.2024
(51) Int. Cl.: H10B 12/00, H10D 30/67

(54) **SEMICONDUCTOR DEVICE INCLUDING VERTICAL CHANNEL TRANSISTORS**
HALBLEITERBAUELEMENT MIT VERTIKALKANALTRANSISTOREN
DISPOSITIF SEMI-CONDUCTEUR COMPRENANT DES TRANSISTORS À CANAL VERTICAL

(30) Priority: 13.02.2024 KR 20240020417
(43) Date of publication of application: 20.08.2025
(73) Proprietor: Samsung Electronics Co., Ltd, Suwon-si, Gyeonggi-do 16677 (KR)
(72) Inventor: JEONG, Moonyoung, 16677 Suwon-si, Gyeonggi-do (KR)
(74) Representative: Kuhnen & Wacker Patent- und Rechtsanwaltsbüro PartG mbB

(56) References cited:
- US-A1- 2021 057 419
- US-A1- 2023 371 243

## Description

### BACKGROUND

The present inventive concepts relate to a semiconductor device, and more particularly, to a semiconductor device including vertical channel transistors.

As the design rules of semiconductor devices are reduced, fabrication techniques have been improved to enhance the integration, operating speed, and yield of these devices. To address these advancements, vertical channel transistors have been proposed to improve integration, resistance, current driving capability, and so forth.

US 2021/057419 A1 discloses a semiconductor memory device including a substrate having a cell region and a contact region with a peripheral circuit region, first and second stacks on the cell region, and a first peripheral transistor on the peripheral circuit region. Each of the first and second stacks includes semiconductor patterns stacked, in a vertical direction, on the cell region, bit lines stacked in the vertical direction on the cell region and respectively connected to first ends of the semiconductor patterns, each of the bit lines extending, in a horizontal direction with respect to the upper surface of the substrate, from the cell region to the contact region, and a word line disposed adjacent to the semiconductor patterns and extending in the vertical direction from the cell region of the substrate. The first peripheral transistor is disposed between the bit lines of the first stack and the bit lines of the second stack.

US 2023/371243 A1 discloses a semiconductor memory device including a peripheral gate structure disposed on a substrate, a bit line disposed on the peripheral gate structure and extending in a first direction, a shielding structure disposed adjacent to the bit line on the peripheral gate structure and extending in the first direction, a first word line disposed on the bit line and the shielding structure and extending in a second direction, a second word line disposed on the bit line and the shielding structure, extending in the second direction, and spaced apart from the first word line in the first direction, first and second active patterns disposed on the bit line and disposed between the first and second word lines, and contact patterns connected to the first and second active patterns.

### SUMMARY

Some embodiments of the present inventive concepts provide a semiconductor device as a memory device having improved electrical characteristics and increased integration as set out in the appended claims.

### BRIEF DESCRIPTION OF DRAWINGS

FIGS. 1A illustrates a block diagram showing a semiconductor device according to some embodiments of the present inventive concepts.
FIG. 1B illustrates a simplified perspective view showing a semiconductor memory device according to some embodiments of the present inventive concepts.
FIG. 2 illustrates a simplified perspective view showing a semiconductor device according to some embodiments of the present inventive concepts.
FIG. 3 illustrates a cross-sectional view taken along line A-A' of FIG. 2.
FIG. 4 illustrates a plan view illustrating a memory block according to some embodiments of the present inventive concepts.
FIG. 5A illustrates a simplified enlarged view inversely showing section P1 of FIG. 3.
FIG. 5B illustrates a detailed enlarged view inversely showing section P1 of FIG. 3.
FIG. 6 illustrates an enlarged view showing section P2 of FIG. 3.
FIG. 7A illustrates an enlarged view showing section P3 of FIG. 3.
FIG. 7B illustrates an enlarged view inversely showing section P4 of FIG. 7A.
FIG. 7C illustrates an enlarged view showing section P3 of FIG. 3.
FIGS. 8A to 8J illustrate cross-sectional views showing a method of fabricating a semiconductor device of FIG. 3.
FIGS. 9 and 10 illustrate cross-sectional views showing a semiconductor device according to some embodiments of the present inventive concepts.
FIG. 11 illustrates a cross-sectional view taken along line A-A' of FIG. 2.
FIGS. 12A to 12E illustrate cross-sectional views showing a method of fabricating a semiconductor device of FIG. 11.
FIG. 13A illustrates a cross-sectional view showing a semiconductor device according to some embodiments of the present inventive concepts.
FIGS. 13B to 13D illustrate circuit diagrams showing a semiconductor device that has a structure of FIG. 13A.
FIGS. 14A to 14D illustrate cross-sectional views showing a semiconductor device according to some embodiments of the present inventive concepts.
FIGS. 15A to 15E illustrate cross-sectional views showing a semiconductor device according to some embodiments of the present inventive concepts.
FIG. 16A illustrates a cross-sectional view showing a semiconductor device according to some embodiments of the present inventive concepts.
FIG. 16B illustrates a circuit diagram showing a semiconductor device of FIG. 16A.
FIG. 17A illustrates a cross-sectional view showing a semiconductor device according to some embodiments of the present inventive concepts.
FIGS. 17B and 17C illustrate circuit diagrams showing a semiconductor device of FIG. 17A.
FIG. 18A illustrates a cross-sectional view showing a semiconductor device according to some embodiments of the present inventive concepts.
FIGS. 18B and 18C illustrate circuit diagrams showing a semiconductor device of FIG. 18A.
FIG. 19A illustrates a plan view showing a semiconductor device according to some embodiments of the present inventive concepts.
FIG. 19B illustrates a cross-sectional view taken along line B-B' of FIG. 19A.
FIG. 20 illustrates a circuit diagram showing a logic transistor according to some embodiments of the present inventive concepts.
FIG. 21A illustrates a plan view showing a logic transistor according to some embodiments of the present inventive concepts.
FIG. 21B illustrates a cross-sectional view taken along line C-C' of FIG. 21A.
FIG. 22A illustrates a plan view showing a logic transistor according to some embodiments of the present inventive concepts.
FIG. 22B illustrates a cross-sectional view taken along line C-C' of FIG. 22A.
FIG. 23 illustrates a plan view showing a logic transistor according to some embodiments of the present inventive concepts.
FIG. 24A illustrates a plan view showing a logic transistor according to some embodiments of the present inventive concepts.
FIG. 24B illustrates a cross-sectional view taken along line C-C' of FIG. 24A.
FIG. 25 illustrates a plan view showing a logic transistor according to some embodiments of the present inventive concepts.
FIG. 26A illustrates a plan view showing a logic transistor according to some embodiments of the present inventive concepts.
FIG. 26B illustrates a cross-sectional view taken along line C-C' of FIG. 26A.

### DETAILED DESCRIPTION OF EMBODIMENTS

A semiconductor device and a method of fabricating the same will hereinafter be discussed according to some embodiments of the present inventive concepts in conjunction with the accompanying drawings. In this description, the term "bottom electrode" may be called a first electrode, and the term "top electrode" may be called a second electrode. In this description, such terms as "first" and "second" may be used to simply distinguish identical or similar components from each other, and the sequence of such terms may be changed in accordance with the order of mention.

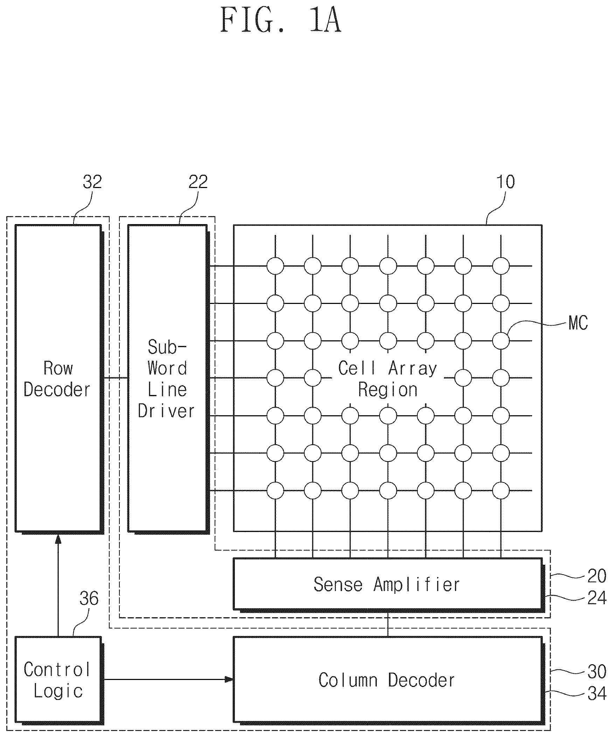

FIGS. 1A illustrates a block diagram showing a semiconductor device according to some embodiments of the present inventive concepts.

Referring to FIG. 1A, a semiconductor memory device according to the present embodiment may include a cell array region 10. The cell array region 10 may include word lines WL and bit lines BL that intersect each other. A plurality of memory cells MC may be two-dimensionally or three-dimensionally disposed on the cell array region 10. Each of the memory cells MC may be connected between the word line WL and the bit line BL that cross each other.

A core circuit section 20 may be disposed around the cell array region 10. The core circuit section 20 may include a sub-word line driver 22 and a sense amplifier 24. A peripheral circuit section 30 may be disposed around the core circuit section 20. A row decoder 32, a column decoder 34, and a control logic 36 may be disposed on the peripheral circuit section 30.

The row decoder 32 may decode a refresh address signal or a row address signal that is input from outside. In response to the row address signal or the refresh address signal, the sub-word line driver 22 may serve to select a specific word line WL.

In response to an address that is decoded from the column decoder 34, the sense amplifier 24 may detect and amplify a voltage difference between a selected bit line BL and a reference bit line, and may then output the amplified voltage difference.

The column decoder 34 may provide a data delivery path between the sense amplifier 24 and an external device (e.g., a memory controller). The column decoder 34 may decode an address that is input from the outside and may select one of the bit lines BL.

The control logic 36 may generate control signals that control operations to write data to a memory cell array of the cell array region 10 and/or to read data from a memory cell array of the cell array region 10.

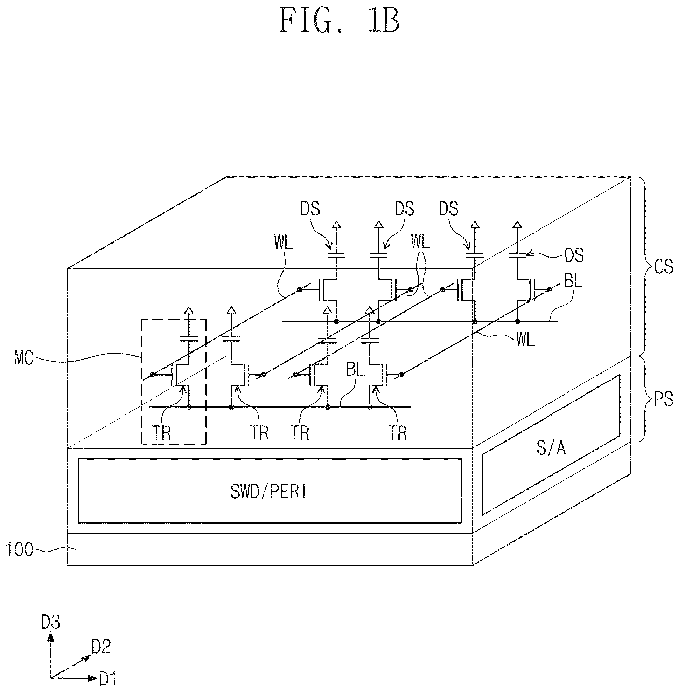

FIG. 1B illustrates a simplified perspective view showing a semiconductor memory device according to some embodiments of the present inventive concepts.

Referring to FIG. 1B, a semiconductor memory device includes a substrate 100, a peripheral structure PS, and a cell structure CS that are sequentially stacked. Unlike FIG. 1B, the cell structure CS may be positioned between the substrate 100 and the peripheral structure PS. The peripheral structure PS may be called a peripheral circuit structure. The cell structure CS may be called a cell array structure.

The peripheral structure PS includes the core circuit section 20 and the peripheral circuit section 30 of FIG. 1A. The core circuit section 20 may include sub-word line driver circuits SWD and sense amplifier circuits S/A. The peripheral circuit section 30 may include peripheral circuits PERI.

The cell structure CS may have various structures of a memory cell, such as dynamic random access memory (DRAM), vertical NAND (VNAND), Flash memory, resistive RAM (ReRAM), ferroelectric random access memory (FeRAM), phase change random access memory (PRAM), and static random access memory (SRA).

According to an embodiment, the cell structure CS may include bit lines BL, word lines WL, and memory cells MC between the bit lines BL and the word lines WL. The memory cells MC may be two-dimensionally or three-dimensionally arranged on a plane elongated in first and second directions D1 and D2 that intersect each other. Each of the memory cells MC may include a selection element TR and a data storage element DS.

The selection element TR may be a field effect transistor (FET). A gate electrode of a transistor may be connected to the word line WL, and source/drain terminals of the transistor may be correspondingly connected to the bit line BL and the data storage element DS. According to some embodiments, a vertical channel transistor (VCT) may be included as the selection element TR of each memory cell MC. The vertical channel transistor may have a structure in which a channel length extends in a direction (or a third direction D3) perpendicular to a top surface of the substrate 100.

The data storage element DS may include a capacitor, a magnetic tunnel junction pattern, or a variable resistor. In the present embodiment, a capacitor may be provided as the data storage element DS of each memory cell MC.

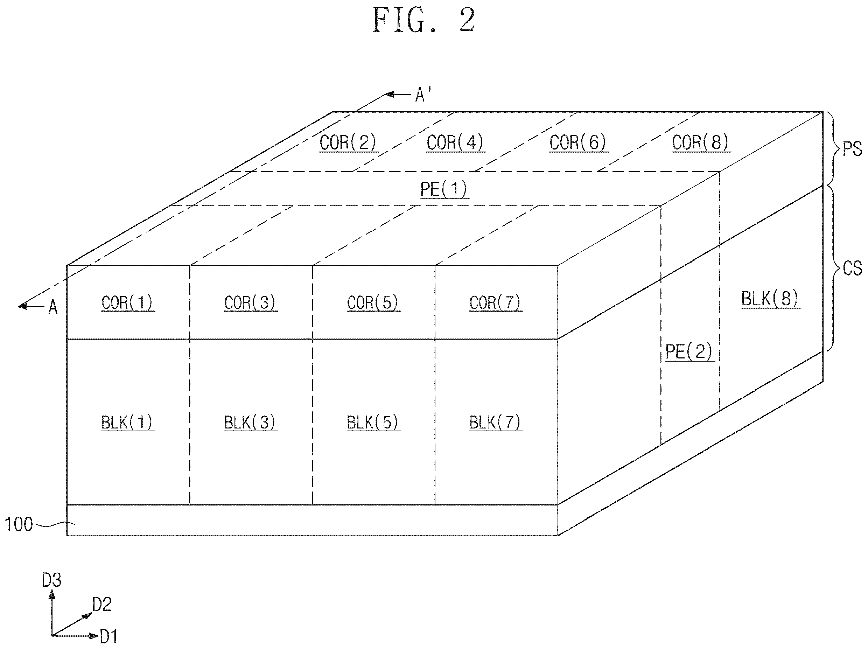

FIG. 2 illustrates a simplified perspective view showing a semiconductor device according to some embodiments of the present inventive concepts.

Referring to FIG. 2, in a semiconductor memory device, a cell structure CS and a peripheral structure PS are sequentially stacked on a substrate 100. The substrate 100 may be a silicon substrate, a silicon-on-insulator (SOI) substrate, or a dielectric substrate. The peripheral structure PS includes a plurality of core circuit sections COR. For example, the peripheral structure PS may include a first peripheral circuit section PE(1) and first to eighth core circuit sections COR(1) to COR(8) that are two-dimensionally arranged along a first direction D1 and a second direction D2. The first, third, fifth, and seventh core circuit sections COR(1), COR(3), COR(5), and COR(7) may be positioned in a front portion of the peripheral structure PS. The second, fourth, sixth, and eighth core circuit sections COR(2), COR(4), COR(6), and COR(8) may be positioned in a rear portion of the peripheral structure PS. The first peripheral circuit section PE(1) may be positioned in a region between the first, third, fifth, and seventh core circuit sections COR(1), COR(3), COR(5), and COR(7) and the second, fourth, sixth, and eighth core circuit sections COR(2), COR(4), COR(6), and COR(8). Although the present embodiment discloses eight core circuit sections COR, the number of core circuit sections is not limited thereto and may be less than eight or equal to or greater than nine. The arrangement of the first to eighth core circuit sections COR(1) to COR(8) and the first peripheral circuit section PE(1) may be variously changed without being limited to that of FIG. 2.

The cell structure CS includes memory blocks BLK that are two-dimensionally arranged along the first direction D1 and the second direction D2. Each of the memory blocks BLK may include various memory cells such as DRAM, VNAND, Flash memory, ReRAM, FeRAM, PRAM, and SRAM. The memory blocks BLK may include first to eighth memory blocks BLK(1) to BLK(8). The first, third, fifth, and seventh memory blocks BLK(1), BLK(3), BLK(5), and BLK(7) may be positioned in a front portion of the cell structure CS. The second, fourth, sixth, and eighth memory blocks BLK(2), BLK(4), BLK(6), and BLK(8) may be positioned in a rear portion of the cell structure CS.

The cell structure CS may further include a second peripheral circuit section PE(2) between the memory blocks BLK. The second peripheral circuit section PE(2) may be positioned in a space between the first, third, fifth, and seventh memory blocks BLK(1), BLK(3), BLK(5), and BLK(7) and the second, fourth, sixth, and eighth memory blocks BLK(2), BLK(4), BLK(6), and BLK(8). Although the present embodiment discloses eight memory blocks BLK, the number of the memory blocks BLK is not limited thereto and may be less than eight or equal to or greater than nine. The arrangement of the first to eighth memory blocks BLK(1) to BLK(8) and the second peripheral circuit section PE(2) may be variously changed without being limited to that of FIG. 2. The cell structure CS may exclude the second peripheral circuit section PE(2).

The first to eighth memory blocks BLK(1) to BLK(8) may respectively vertically overlap the first to core circuit sections COR(1) to COR(8). The first to eighth memory blocks BLK(1) to BLK(8) may be respectively connected to the first to core circuit sections COR(1) to COR(8). The second peripheral circuit section PE(2) may vertically overlap the first peripheral circuit section PE(1). The second peripheral circuit section PE(2) may be connected to the first peripheral circuit section PE(1). Each of the first to eighth memory blocks BLK(1) to BLK(8) may include the bit lines BL, the word lines WL, and the memory cells MC that are discussed with reference to FIGS. 1A and 1B. Each of the first to eighth core circuit sections COR(1) to COR(8) may include the sub-word line driver 22 and the sense amplifier 24 that are discussed with reference to FIG. 1A. The row decoders 32, the column decoders 34, and the control logics 36 may be disposed on the first peripheral circuit section PE(1) and the second peripheral circuit section PE(2).

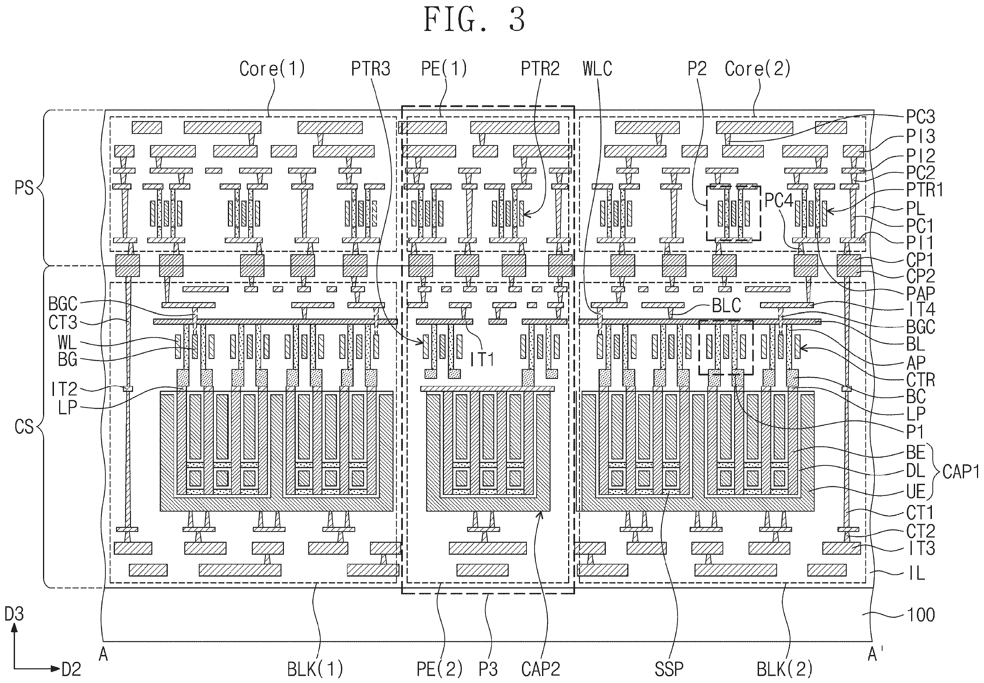

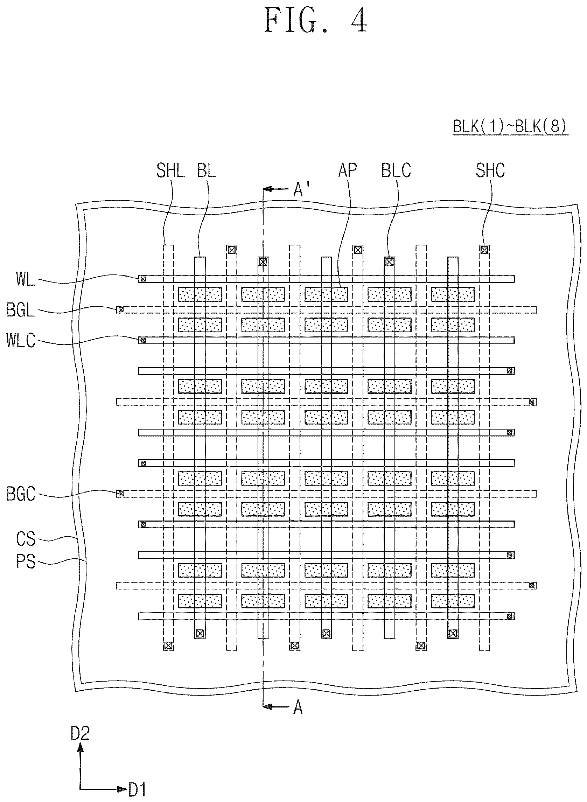

FIG. 3 illustrates a cross-sectional view taken along line A-A' of FIG. 2. FIG. 4 illustrates a plan view illustrating a memory block according to some embodiments of the present inventive concepts. First and second memory blocks BLK(1) and BLK(2) of FIG. 3 may correspond to a cross-section taken along line A-A' of FIG. 4.

Referring to FIGS. 2 and 3, a cell structure CS and a peripheral structure PS may be sequentially stacked on a substrate 100. The substrate 100 may be a silicon substrate, a silicon-on-insulator (SOI) substrate, or a dielectric substrate.

Referring to FIGS. 2 to 4, the cell structure CS may include first to eighth memory blocks BLK(1) to BLK(8) and a second peripheral circuit section PE(2). Each of the first to eighth memory blocks BLK(1) to BLK(8) may include cell connection pads CP2, a cell interlayer dielectric layer IL, cell transistors CTR, bit lines BL, shield lines SHL, word lines WL, back gate lines BGL, cell capacitors CAP1, first to fourth cell wiring lines IT1 to IT4, and first to third cell contact plugs CT1 to CT3. The cell interlayer dielectric layer IL may have a single-layered or multi-layered structure of at least one selected from silicon oxide, silicon nitride, silicon oxynitride, and porous dielectrics. The second peripheral circuit section PE(2) may include third peripheral transistors PTR3, peripheral capacitors CAP2, first to fourth cell wiring lines IT1 to IT4, and first to third cell contact plugs CT1 to CT3.

There are no limitations to those shown in figures, but there may be various changes in terms of the number, height, thickness, and stacking numbers of the cell connection pads CP2, the cell interlayer dielectric layer IL, the cell transistors CTR, the bit lines BL, the shield lines SHL, the word lines WL, the back gate lines BGL, the cell capacitors CAP1, the first to fourth cell wiring lines IT1 to IT4, the first to third cell contact plugs CT1 to CT3, the third peripheral transistors PTR3, and the peripheral capacitors CAP2.

The cell connection pads CP2 may be in contact with corresponding peripheral connection pads CP1. The cell interlayer dielectric layer IL may have a top surface in contact with a bottom surface of a peripheral interlayer dielectric layer PL. The first cell wiring line IT1 may be connected to first terminals of the third peripheral transistors PTR3. The second cell wiring line IT2 may be connected to second terminals of the third peripheral transistors PTR3 and the cell transistors CTR. The third cell wiring lines IT3 may be connected to top electrodes UE of the peripheral capacitors CAP2 and the cell capacitors CAP1. The fourth cell wiring line IT4 may connect the first cell wiring line IT1 to the cell connection pad CP2. The third cell wiring lines IT3 may be thicker than the fourth cell wiring line IT4.

The first cell contact plug CT1 may connect the third cell wiring line IT3 to the second cell wiring line IT2. The second cell contact plugs CT2 may be connected to corresponding third cell wiring lines of the third cell wiring lines IT3, respectively. The third cell contact plug CT3 may connect the cell connection pad CP2 to the fourth cell wiring lines IT4 or may connect the cell connection pad CP2 to the second cell wiring line IT2.

The following description will focus on the first to eighth memory blocks BLK(1) to BLK(8).

Referring to FIGS. 3 and 4, the bit lines BL and the shield lines SHL may extend in a second direction D2 and may be spaced apart from each other in a first direction D1. The shield lines SHL may be correspondingly interposed between the bit lines BL. The bit lines BL and the shield lines SHL may be located at the same level. The first direction D2 may be perpendicular to the first direction D1. In an embodiment, each of the shield lines SHL and each of the bit lines BL may be alternately arranged in the first direction D1.

A bit-line contact plug BLC may penetrate a portion of the cell interlayer dielectric layer IL to contact the bit line BL. A shield-line contact plug SHC may penetrate a portion of the cell interlayer dielectric layer IL to contact the shield line SHL. A word-line contact plug WLC may penetrate a portion of the cell interlayer dielectric layer IL to contact the word line WL. A back gate contact plug BGC may penetrate a portion of the cell interlayer dielectric layer IL to come into connection with the back gate line BGL. The term "contact," as used herein, refers to a direct connection (i.e., physical touching) unless the context indicates otherwise.

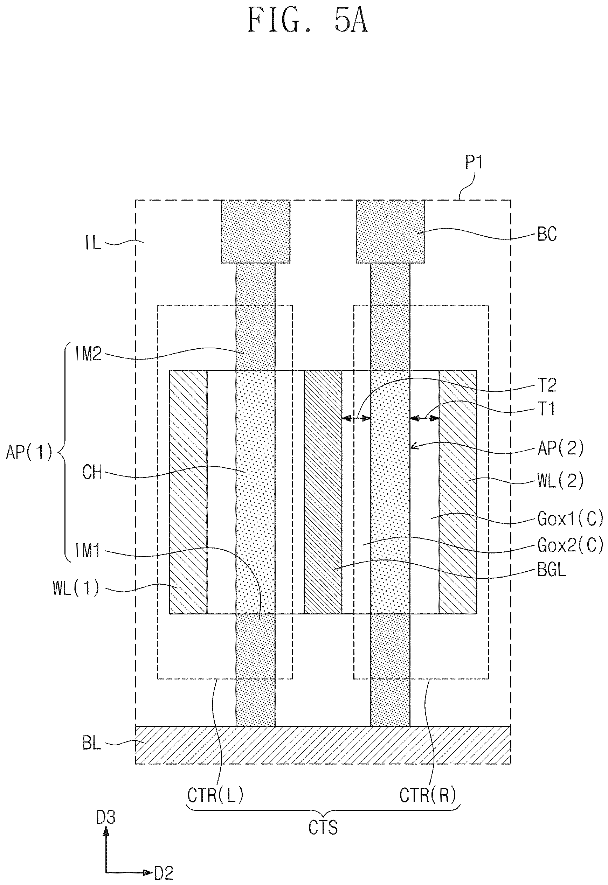

FIG. 5A illustrates a simplified enlarged view inversely showing section P1 of FIG. 3.

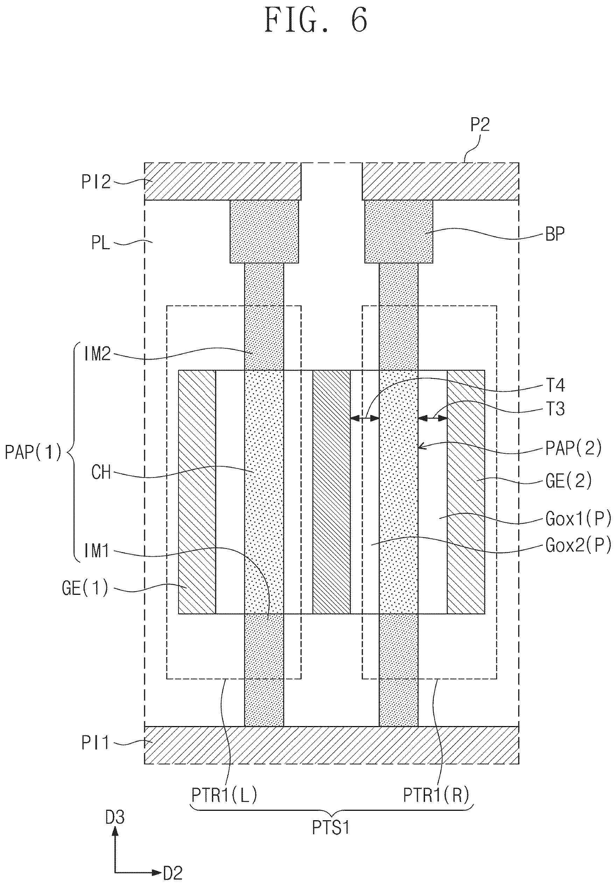

Referring to FIGS. 2 to 5A, the cell transistors CTR may be disposed on each of the first to eighth memory blocks BLK(1) to BLK(8). The cell transistors CTR may correspond to the selection element TR of FIG. 1B. The cell transistors CTR may correspondingly include active patterns AP. In this description, the term "active pattern AP" may be called a cell active pattern to distinguish from a peripheral active pattern PAP of FIG. 6. The active patterns AP may include a pair of first and second active patterns AP(1) and AP(2) that are adjacent to each other in the second direction D2. Each of the pair of active patterns AP(1) and AP(2) may include a channel region CH and first and second impurity regions IM1 and IM2. The first impurity regions IM1 of the active patterns AP may be in contact with the bit lines BL. The second impurity regions IM2 of the active patterns AP may be in contact with storage node contacts BC. For example, the first impurity region IM1, the channel region CH, and the second impurity region IM2 may be arranged in the third direction D3. The first and second impurity regions IM1 and IM2 may be disposed at a lower surface of the channel region CH and an upper surface of the channel region CH, respectively.

The word lines WL may include a pair of first and second word lines WL(1) and WL(2) that are adjacent to each other in the second direction D2. The first word line WL(1) may be adjacent to the channel region CH of the first active pattern AP(1). The second word line WL(2) may be adjacent to the channel region CH of the second active pattern AP(2). In an embodiment, the pair of active patterns AP(1) and AP(2) may be disposed in a space between the first word line WL(1) and the second word line WL(2). The configuration of the pair of word lines WL(1) and WL(2) and the pair of active patterns AP(1) and AP(2) may be repeatedly arranged along the second direction D2 to form each of the first to eighth memory blocks BLK(1) to BLK(8).

First gate dielectric layers Gox1 may be disposed between the first and second word lines WL(1) and WL(2) and the first and second active patterns AP(1) and AP(2), respectively. The first gate dielectric layers Gox1 may extend lengthwise in the first direction D1 parallel to the first and second word lines WL(1) and WL(2).

The back gate line BGL may be interposed between a pair of first and second active patterns AP(1) and AP(2). The word lines WL and the back gate lines BGL may extend lengthwise along the first direction D1 as shown in FIG. 4. A second gate dielectric layer Gox2 may be disposed between the back gate line BGL and each of the first and second active patterns AP(1) and AP(2). The first gate dielectric layers Gox1 and the second gate dielectric layer Gox2 may each be formed of, for example, a single layer or multiple layers including at least one selected from a silicon oxide layer, a silicon oxynitride layer, and a high-k dielectric layer whose a dielectric constant is greater than a dielectric constant of a silicon oxide layer. The high-k dielectric layer may be formed of metal oxide or metal oxynitride. For example, the high-k dielectric layer used as the first and second gate dielectric layers Gox1 and Gox2 may be formed of HfO₂, HfSiO, HfSiON, HfTaO, HfTiO, HfZrO, ZrO₂, AlxO₃, or a combination thereof, but the present inventive concepts are not limited thereto. According to some embodiments, the second gate dielectric layer Gox2 may be formed of a single layer or multiple layers including a dielectric material whose a dielectric constant is less than a dielectric contestant of a silicon oxide layer. For example, the second gate dielectric layer Gox2 may include SiOCH or an air gap. In some embodiments, the dielectric constant of the second gate dielectric layer Gox2 may be smaller than the dielectric constant of the first gate dielectric layer Gox1. In some embodiments, the back gate line BGL may be disposed in a space between the pair of active patterns AP(1) and AP(2) which are repeatedly disposed in each of the first to eighth memory blocks BLK(1) to BLK(8). No back gate line may be present in a space between two pairs of active patterns AP(1) and AP(2) which are repeatedly disposed in each of the first to eighth memory blocks BLK(1) to BLK(8), and no active pattern may be present in a space between two pairs of word lines WL(1) and WL(2) which are repeatedly disposed in each of the first to eighth memory blocks BLK(1) to BLK(8). The term "air" as discussed herein, may refer to atmospheric air, or other gases that may be present during the manufacturing process.

The first gate dielectric layers Gox1 may have a first thickness T1. The second gate dielectric layer Gox2 may have a second thickness T2. The first thickness T1 may be the same as or different from the second thickness T2. The second gate dielectric layer Gox2 may be called a back gate dielectric layer.

A portion of the first word line WL(1) and the first active pattern AP(1) adjacent thereto may constitute a left cell transistor CTR(L). A portion of the second word line WL(2) and the second active pattern AP(2) adjacent thereto may constitute a right cell transistor CTR(R). The left cell transistor CTR(L) and the right cell transistor CTR(R) may constitute a cell transistor structure CTS. In some embodiments, the portion of the first word line WL(1) may overlap the first active pattern AP(1) in the second direction D2 to form the left cell transistor CTR(L), and the portion of the second word line WL(2) may overlap the second active pattern AP(2) in the second direction D2.

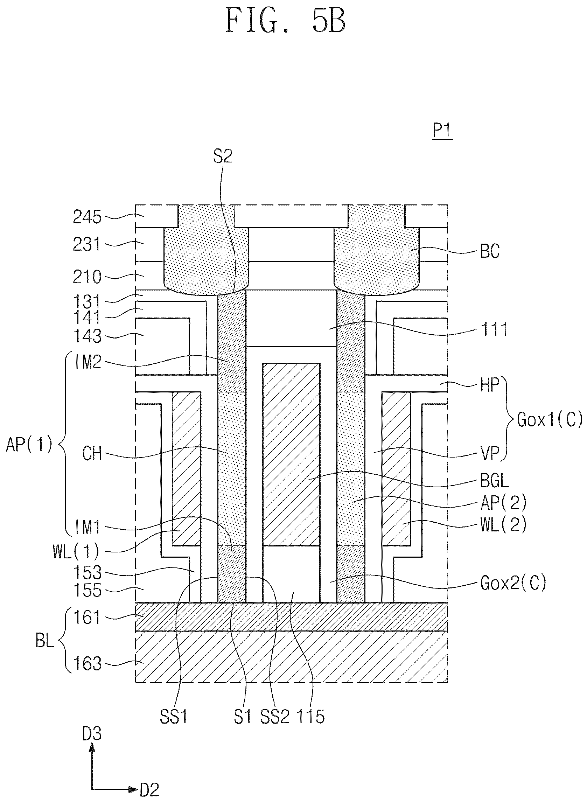

FIG. 5B illustrates a detailed enlarged view inversely showing section P1 of FIG. 3.

Referring to FIG. 5B, each of the bit lines BL may include a polysilicon pattern 161 and a metal pattern 163 that are sequentially stacked. Although not shown in FIG. 5B, each of the shield lines SHL may have at least one of a poly silicon pattern corresponding to the polysilicon pattern 161 of each of the bit lines BL and a metal pattern corresponding to the metal pattern 163 of each of the bit lines BL. Each of the bit lines BL may have a top surface at a level which is the same as or different from a level of a top surface of each of the shield lines SHL. Each of the bit lines BL may have a bottom surface at a level which is the same as or different from a level of a bottom surface of each of the shield lines SHL. The metal pattern 163 may include or may be formed of one or more of conductive metal nitride (e.g., titanium nitride or tantalum nitride) and metal (e.g., tungsten, titanium, or tantalum). The metal pattern 163 may include or may be formed of metal silicide, such as titanium silicide, cobalt silicide, and nickel silicide.

Referring to FIGS. 5A and 5B, the active patterns AP may be formed of a monocrystalline semiconductor material, an oxide semiconductor material, or a two-dimensional semiconductor material. The oxide semiconductor material may be indium-gallium-zinc oxide. The two-dimensional semiconductor material may be MoS₂, WS₂, MoSe₂, or WSe₂. For example, the active patterns AP may be formed of single crystalline silicon.

Each of the first active pattern AP(1) and the second active pattern AP(2) may have a length in the first direction D1 as shown in FIG. 4, a width in the second direction D2, and a height in a third direction D3 perpendicular to the first and second directions D1 and D2. Each of the first active pattern AP(1) and the second active pattern AP(2) may have a substantially uniform width. Each of the first active pattern AP(1) and the second active pattern AP(2) may have a width of several nanometers to tens nanometers. For example, each of the first active pattern AP(1) and the second active pattern AP(2) may have a width of about 1 nm to about 30 nm, for example, about 1 nm to about 10 nm. Each of the first active pattern AP(1) and the second active pattern AP(2) may have a length greater than a line-width of the bit line BL.

Referring to FIG. 5B, each of the first active pattern AP(1) and the second active pattern AP(2) may have a first surface S1 and a second surface S2 that are opposite to each other in the third direction D3. For example, the first surfaces S1 of the first and second active patterns AP(1) and AP(2) may be in contact with the polysilicon pattern 161 of the bit line BL or with the metal pattern 163 when the polysilicon pattern 161 is omitted. The second surfaces S2 of the first and second active patterns AP(1) and AP(2) may be in contact with the storage node contacts BC, respectively.

Each of the first active pattern AP(1) and the second active pattern AP(2) may have a first lateral surface SS1 and a second lateral surface SS2 that are opposite to each other in the second direction D2. The first lateral surface SS1 of the first active pattern AP(1) may be adjacent to the first word line WL(1), and the second lateral surface SS2 of the second active pattern AP(2) may be adjacent to the second word line WL(2). For example, the first lateral surface SS1 of the first active pattern AP(1) may be adjacent to the first word line WL(1), and the second lateral surface SS2 of the first active pattern AP(1) may be adjacent to the back gate word line BGL. The first lateral surface SS1 of the second active pattern AP(2) may be adjacent to the second word line WL(2), and the second lateral surface SS2 of the second active pattern AP(2) may be adjacent to the back gate word line BGL.

The first and second impurity regions IM1 and IM2 may be regions doped with N-type or P-type impurities in each of the first and second active patterns AP(1) and AP(2). The channel region CH may not be doped with impurities or may be doped with impurities whose a conductivity type is different from a conductivity type of impurities doped in the first and second impurity regions IM1 and IM2.

The channel regions CH of the first and second active patterns AP(1) and AP(2) may be controlled by the first and second word lines WL(1) and WL(2) and the back gate lines BGL when a semiconductor device is operated.

Referring to FIGS. 4 and 5B, the back gate lines BGL may be disposed spaced apart at a certain interval from each other in the second direction D2 on the bit lines BL. The back gate lines BGL may extend lengthwise in the first direction D1 across the bit lines BL.

When viewed in a vertical direction, the back gate lines BGL may have a height less than that of the first active pattern AP(1) and the second active pattern AP(2). The back gate line BGL may have a first surface adjacent to the bit line BL and a second surface adjacent to the storage node contact BC. The first and second surfaces of the back gate line BGL may be vertically spaced apart from the first and second surfaces S1 and S2 of each of the first and second active patterns AP(1) and AP(2), respectively.

Each of the back gate lines BGL may have a top surface at a level which is the same as or different from a level of a top surface of each of the word lines WL. Each of the back gate lines BGL may have a bottom surface at a level which is the same as or different from that of a bottom surface of each of the word lines WL.

The first word line WL(1), the second word line WL(2), and the back gate line BGL may include or may be formed of, for example, doped polysilicon, conductive metal nitride (e.g., titanium nitride or tantalum nitride), metal (e.g., tungsten, titanium, or tantalum), conductive metal silicide, conductive metal oxide, or a combination thereof.

The back gate line BGL may be provided with a negative voltage when a semiconductor memory device is operated, and may increase a threshold voltage of a vertical channel transistor. For example, as the vertical channel transistor reduces in size, a threshold voltage of the vertical transistor may be lowered, thereby increasing a leakage current. With the back gate line BCL supplied with a negative voltage, the reduction of the threshold voltage in the vertical channel transistor may be compensated, thereby preventing the increase of a leakage current.

A portion of the cell interlayer dielectric layer IL may include layers 111, 115, Gox1, Gox2, 131, 141, 143, 153, 155, 210, 231, and 245 each of which is formed of a dielectric material. A first dielectric pattern 111 may be disposed between the first active pattern AP(1) and the second active pattern AP(2) that are adjacent to each other in the second direction D2. The first dielectric pattern 111 may be disposed between the second impurity regions IM2 of the first and second active patterns AP(1) and AP(2). The first dielectric pattern 111 may include or may be formed of, for example, a silicon oxide layer, a silicon nitride layer, or a silicon oxynitride layer.

The second gate dielectric layer Gox2 may be disposed between the back gate line BGL and each of the first and second active patterns AP(1) and AP(2) and between the back gate line BGL and the first dielectric pattern 111. The second gate dielectric layer Gox2 may include vertical parts that cover opposite lateral surfaces of the back gate line BGL and a horizontal part that connects the vertical parts to each other. The horizontal part of the second gate dielectric layer Gox2 may be closer to the storage node contact BC than the bit line BL, and may cover the second surface of the back gate line BGL. The horizontal part of the second gate dielectric layer Gox2 may be disposed between the back gate line BGL and the first dielectric pattern 111.

A back gate capping pattern 115 may be disposed between the back gate line BGL and the bit line BL. The back gate capping pattern 115 may be formed of a dielectric material, and may have a bottom surface in contact with the polysilicon pattern 161 of the bit line BL. The back gate capping pattern 115 may be disposed between the vertical parts of the second gate dielectric layer Gox2. In some embodiments, the back gate capping pattern 115 may extend in the first direction D1 along the first surface, adjacent to the bit line BL, of the back gate line BGL. A thickness of a portion of the back gate capping pattern 115 between the bit lines BL may be different from a thickness of a portion of the back gate capping pattern 115 on the bit lines BL.

The first gate dielectric layer Gox1 may cover the first lateral surface SS1 of the first active pattern AP(1) and the second lateral surfaces SS2 of the second active pattern AP(2). The first gate dielectric layer Gox1 may have a substantially uniform thickness. Each of the first gate dielectric layers Gox1 may include a vertical part VP adjacent to the first and second active patterns AP(1) and AP(2) and a horizontal part HP that protrudes in the second direction D2 from the vertical part VP. For example, the vertical part VP may extend in the third direction D3 along the first lateral surface SS1 of each of the first and second active patterns AP(1) and AP(2). The horizontal part HP may be connected to an upper end of the vertical part VP and expend in the second direction D2 and away from a corresponding one of the first and second active patterns AP(1) and AP(2).

For example, a pair of first and second word lines WL(1) and WL(2) may be disposed on the horizontal part HP of each of the first gate dielectric layers Gox1. The first gate dielectric layers Gox1 may be disposed spaced apart from each other, and may be mirror-symmetric with each other.

A second dielectric pattern 143 may be disposed between the storage node contact BC and the horizontal part HP of the first gate dielectric layer Gox1. For example, the second dielectric pattern 143 may include or may be formed of silicon oxide. First and second etch stop layers 131 and 141 may be disposed between the second dielectric pattern 143 and the second impurity regions IM2 of the first and second active patterns AP(1) and AP(2).

On the first gate dielectric layer Gox1, a third dielectric pattern 155 may separate the first and second word lines WL(1) and WL(2) from each other. The third dielectric pattern 155 may extend in the first direction D1 between the first and second word lines WL(1) and WL(2). A first capping layer 153 may be disposed between the third dielectric pattern 155 and the first and second word lines WL(1) and WL(2). The first capping layer 153 may have a substantially uniform thickness.

The storage node contacts BC may penetrate an interlayer dielectric layer 231, an upper dielectric layer 245, and an etch stop layer 210 to be correspondingly coupled to the first and second active patterns AP(1) and AP(2). The storage node contacts BC may have a lower width greater than an upper width. The upper dielectric layer 245 may separate neighboring storage node contacts BC from each other. When viewed in a plan view, each of the storage node contacts BC may have a circular shape, an oval shape, a rectangular shape, a square shape, a rhombic shape, a hexagonal shape, or any other suitable shape. The storage node contacts BC may be arranged in a matrix shape along the first direction D1 and the second direction D2. The storage node contacts BC may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, Ru, TiN, NiSi, CoSi, IrOx, RuOx, or a combination thereof, but the present inventive concepts are not limited thereto.

Referring to FIG. 3, landing pads LP may be disposed underneath the storage node contacts BC. When viewed in a plan view, each of the landing pads LP may have a circular shape, an oval shape, a rectangular shape, a square shape, a rhombic shape, a hexagonal shape, or any other suitable shape. The landing pads LP may completely or partially vertically overlap the storage node contacts BC. When viewed in a plan view, the landing pads LP may be arranged in a matrix shape along the first direction D1 and the second direction D2. In some embodiments, the landing pads LP may be arranged in a honeycomb shape when viewed in a plan view. The landing pads LP may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but the present inventive concepts are not limited thereto.

The cell capacitors CAP1 may be correspondingly connected to the landing pads LP. The cell capacitors CAP1 may have an inverse structure. For example, bottom electrodes BE may be positioned above a top electrode UE.

The bottom electrodes BE may be correspondingly disposed underneath the landing pads LP. The bottom electrodes BE may be correspondingly electrically connected to the first and second active patterns AP(1) and AP(2). Each of the bottom electrodes BE may have a pillar shape or a hollow cup shape.

The bottom electrodes BE may be disposed in a honeycomb shape or a matrix shape along the first direction D1 and the second direction D2. The bottom electrodes BE may completely or partially overlap the landing pads LP. The bottom electrodes BE may be entirely or partially in contact with bottom surfaces of the landing pads LP, respectively. There may be a constant interval between the bottom electrodes BE. The bottom electrodes BE may include at least one selected from impurity-doped silicon, metal, metal oxide, and metal nitride. For example, the bottom electrodes BE may include a titanium nitride layer.

The bottom electrodes BE may have their lower sidewalls in partial contact with support patterns SSP. The support patterns SSP may prevent collapse of the bottom electrodes BE. When viewed in a plan view, the support patterns SSP may have a mesh shape or a plate shape in which a plurality of apertures are formed. The support patterns SSP may be formed of either one layer or two or more layers. The support patterns SSP may be formed of, for example, a single layer or multiple layers including at least one of a silicon nitride (SiN) layer, a silicon boronitride (SiBN) layer, and a silicon carbonitride (SiCN) layer.

A dielectric layer DL may conformally cover the bottom electrodes BE and the support patterns SSP. The dielectric layer DL may be formed of a single or multiple layers including at least one of, for example, a silicon oxide layer and a metal oxide layer such as an aluminum oxide layer having a material whose a dielectric constant is greater than a dielectric constant of a silicon oxide layer. The dielectric layer DL may have a single-layered or a multi-layered structure of at least one of a ferroelectric layer and an antiferroelectric layer. The dielectric layer DL may have a bottom surface covered with the top electrode UE. The top electrode UE may be formed to have a single-layered or a multi-layered structure including at least one of a titanium nitride layer, a tungsten layer, an impurity-doped polysilicon layer, and an impurity-doped silicon-germanium layer. The top electrode UE may have a sidewall aligned with that of the dielectric layer DL.

The bottom electrodes BE, the dielectric layer DL, and the top electrode UE may constitute the cell capacitors CAP1. The cell capacitors CAP1 may correspond to the data storage element DS of FIG. 1B.

In the present inventive concepts, as shown in FIGS. 1A to 3, each of the memory cells MC of the cell structure CS is illustrated to have a 1T1C (1-transistor, 1-capacitor) structure in which one VCT structured cell transistor CTR is connected to one cell capacitor CAP1, but the present inventive concepts are not limited thereto. The dielectric layer DL may be formed of a ferroelectric material, and in this case, each of the memory cells MC may have a 1T1F (1-transistor, 1-ferroelectric capacitor) structure. In some embodiments, one cell transistor CTR may be connected to n numbers of cell capacitors CAP1 (where, n is a natural number equal to or greater than 2), and in this case, each of the memory cells MC may have a 1TnC (1-transistor, n-capacitor) structure. Each of the memory cells MC may have a vertically stacked dynamic random access memory (VS-DRAM) structure in which the active patterns AP are horizontally elongated and vertically stacked and in which the bottom electrode BE is positioned on sides of the active patterns AP. In some embodiments, each of the memory cells MC may have a 1T (1-transistor) DRAM structure formed of the cell transistors CTR without the cell capacitor CAP1.

The following description will focus on the first peripheral circuit section PE(1) and the second peripheral circuit section PE(2).

Referring to FIG. 3, the peripheral structure PS includes first and second peripheral transistors PTR1 and PTR2, first to fourth peripheral contact plugs PC1 to PC4, first to third peripheral wiring lines PI1 to PI3, a peripheral interlayer dielectric layer PL, and peripheral connection pads CP1.

There are no limitations to those shown in figures, but there may be various changes in terms of the number, height, thickness, and stacking numbers of the first and second peripheral transistors PTR1 and PTR2, the first to fourth peripheral contact plugs PC1 to PC4, the first to third peripheral wiring lines PI1 to PI3, the peripheral interlayer dielectric layer PL, and the peripheral connection pads CP1.

Each of the first and second peripheral transistors PTR1 and PTR2 may have a VCT shape. Each of the first and second peripheral transistors PTR1 and PTR2 may be connected to the first and second peripheral wiring lines PI1 and PI2. The first peripheral contact plug PC1 may connect the first and second peripheral wiring lines PI1 and PI2 with each other. Each of the first, second, and third peripheral wiring lines PI1, PI2, and PI3 may be formed of multi-layers. The peripheral interlayer dielectric layer PL may cover the peripheral contact plugs PC1, PC2, PC3, and PC4 and the peripheral wiring lines PI1, PI2, and PI3. The third peripheral wiring line PI3 may have a thickness greater than thicknesses of the first and second peripheral wiring lines PI1 and PI2. The second peripheral contact plugs PC2 may be connected to the second peripheral wiring lines PI2. The third peripheral contact plugs PC3 may be connected to the third peripheral wiring lines PI3. The peripheral connection pads CP1 may be disposed on a bottom end of the peripheral interlayer dielectric layer PL. The fourth peripheral contact plugs PC4 may connect the peripheral connection pads CP1 to the first peripheral wiring lines PI1, respectively.

The peripheral connection pads CP1, the peripheral contact plugs PC1, PC2, PC3, and PC4, and the peripheral wiring lines PI1, PI2, and PI3 may each include metal, such as copper, aluminum, tungsten, titanium, tantalum, titanium nitride, and tantalum nitride. The peripheral interlayer dielectric layer PL may have a single-layered or a multi-layered structure of at least one of silicon oxide, silicon nitride, silicon oxynitride, SiCN, and porous dielectrics.

On each of the core circuit sections COR(1) to COR(8), the first peripheral transistors PTR1, the first to fourth peripheral contact plugs PC1 to PC4, and the first to third peripheral wiring lines PI1 to PI3 may constitute the sense amplifiers 24 and the sub-word line drivers 22.

On the first peripheral circuit section PE(1), the second peripheral transistors PTR2, the first to fourth peripheral contact plugs PC1 to PC4, and the first to third peripheral wiring lines PI1 to PI3 may constitute portions of the row decoders 32, the column decoders 34, and the control logics 36.

FIG. 6 illustrates an enlarged view showing section P2 of FIG. 3. FIG. 6 depicts a cross-section of the first peripheral transistor PTR1.

Referring to FIGS. 3 and 6, the first peripheral transistors PTR1 include peripheral active patterns PAP and a peripheral gate electrode GE adjacent thereto. The peripheral active patterns PAP may include a pair of first and second peripheral active patterns PAP(1) and PAP(2) that are adjacent to each other.

The peripheral active patterns PAP may be formed of a monocrystalline semiconductor material, an oxide semiconductor material, or a two-dimensional semiconductor material. The oxide semiconductor material may be indium-gallium-zinc oxide. The two-dimensional semiconductor material may be MoS2, WS2, MoSe2, or WSe2. For example, the peripheral active patterns PAP may be formed of single crystalline silicon.

A channel region CH and first and second impurity regions IM1 and IM2 are disposed on each of the peripheral active patterns PAP. The first impurity regions IM1 of the peripheral active patterns PAP may be in contact with the first peripheral wiring line PI1. The second impurity regions IM2 of the peripheral active patterns PAP may be in contact with conductive patterns BP. The conductive patterns BP may include or may be formed of the same material as a material of the storage node contacts BC. The conductive patterns BP may be formed of metal, impurity-doped silicon, SiGe, or SiC. Impurities doped in the conductive patterns BP and impurities doped in the first and second impurity regions IM1 and IM2 may have the same conductivity type.

The conductivity type of impurities doped in the first and second impurity regions IM1 and IM2 of the first peripheral transistors PTR1 of FIG. 6 may be the same as or different from the conductivity type of impurities doped in the first and second impurity regions IM1 and IM2 of the cell transistors CTR of FIG. 5A. The first and second impurity regions IM1 and IM2 of the first peripheral transistors PTR1 of FIG. 6 may be doped with first impurities at a first concentration, and the first and second impurity regions IM1 and IM2 of the cell transistors CTR of FIG. 5A may be doped with the first impurities at a second concentration. The second concentration may be greater than the first concentration.

A first peripheral gate electrode GE(1) is adjacent to the channel region CH of the first peripheral active pattern PAP(1). A second peripheral gate electrode GE(2) may be adjacent to the channel region CH of the second peripheral active pattern PAP(2). The first gate dielectric layer Gox1 may be disposed between the peripheral gate electrodes GE and the peripheral active pattern PAP. A peripheral back gate electrode BG may be interposed between a pair of first and second peripheral active patterns PAP(1) and PAP(2). The second gate dielectric layer Gox2 may be disposed between the peripheral back gate electrodes BG and the peripheral active pattern PAP.

The first peripheral gate electrode GE(1) and the first peripheral active pattern PAP(1) adjacent thereto may constitute a first left peripheral transistor PTR1(L). The second peripheral gate electrode GE(2) and the second peripheral active pattern PAP(2) adjacent thereto may constitute a first right peripheral transistor PTR1(R). The first left peripheral transistor PTR1(L) and the first right peripheral transistor PTR1(R) may constitute a first pair transistor structure PTS 1.

A material included in each of the first and second gate dielectric layers Gox1 and Gox2 of the first pair transistor structure PTS1 of FIG. 6 may be the same as or different from a material included in each of the first and second gate dielectric layers Gox1 and Gox2 of the cell transistor structure CTS of FIG. 5A. The first gate dielectric layers Gox1 of the first pair transistor structure PTS1 may have a third thickness T3. The second gate dielectric layers Gox2 of the first pair transistor structure PTS1 may have a fourth thickness T4. The third thickness T3 of FIG. 6 may be the same as or different from the first thickness T1 of the cell transistor structure CTS of FIG. 5A, and for example, the third thickness T3 may be greater than the first thickness T1. The fourth thickness T4 of FIG. 6 may be the same as or different from the second thickness T2 of FIG. 5A, and for example, the fourth thickness T4 may be greater than the second thickness T2.

The second peripheral transistors PTR2 may have a cross-section which is the same as or similar to the cross-section of the first peripheral transistors PTR1. In some embodiments, the second peripheral transistors PTR2 may have a fin field effect transistor (FinFET) structure.

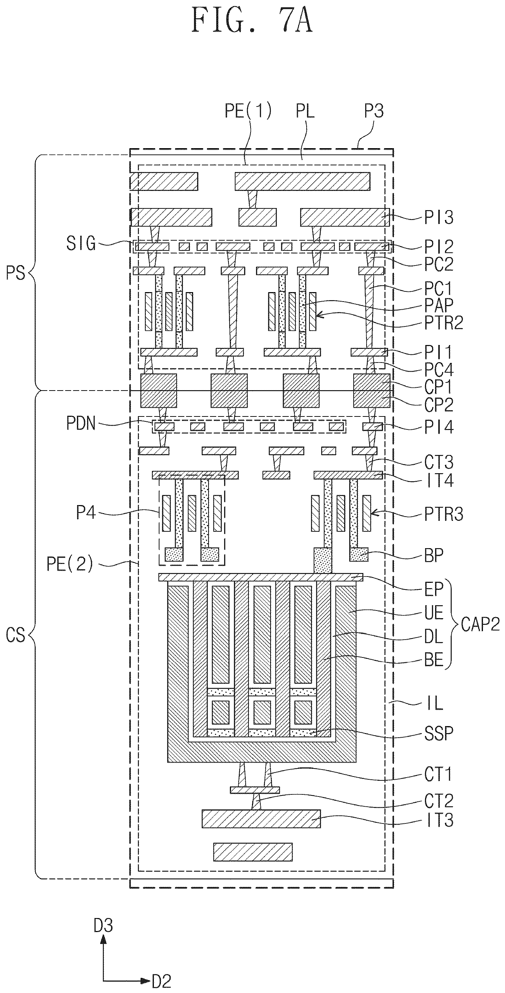

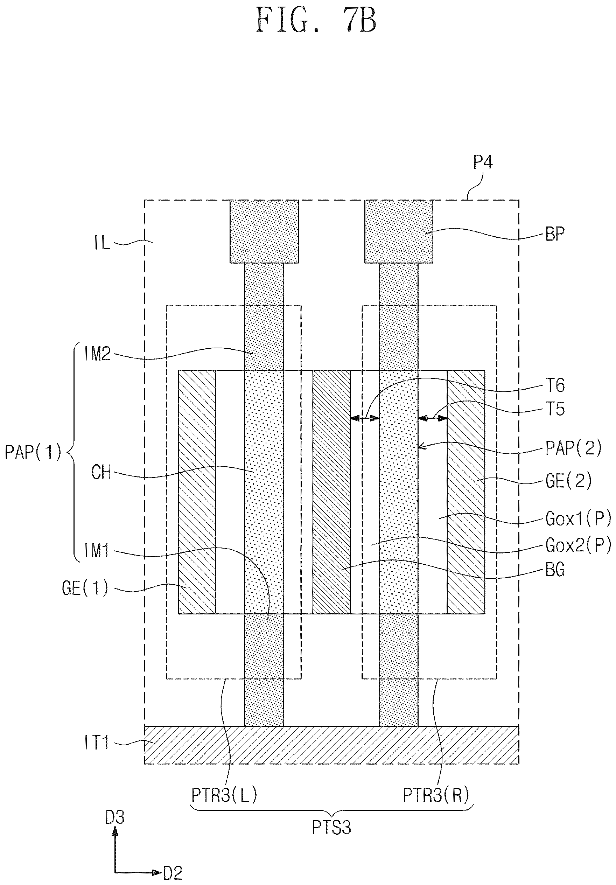

FIG. 7A illustrates an enlarged view showing section P3 of FIG. 3. FIG. 7B illustrates an enlarged view inversely showing section P4 of FIG. 7A.

Referring to FIG. 7A, on the first peripheral circuit section PE(1), some of the second peripheral wiring lines PI2 positioned on the second peripheral transistor PTR2 may be a signal wiring layer SIG. On the second peripheral circuit section PE(2) positioned below the second peripheral transistor PTR2, portions of the fourth cell wiring lines IT4 may constitute a backside power delivery network layer PDN. An interval between the fourth cell wiring lines IT4 on the backside power delivery network layer PDN may be greater than an interval between the second peripheral wiring lines PI2 on the signal wiring layer SIG.

Referring to FIGS. 7A and 7B, the third peripheral transistors PTR3 may be disposed on the second peripheral circuit section PE(2). The third peripheral transistors PTR3 may have a structure which is the same as or similar to a structure of the first peripheral transistors PTR1 of FIG. 6. The third peripheral transistors PTR3 may include peripheral active patterns PAP and peripheral gate electrodes GE adjacent thereto. The peripheral active patterns PAP may include a pair of first and second peripheral active patterns PAP(1) and PAP(2) that are adjacent to each other. Each of the peripheral active patterns PAP may include a channel region CH and first and second impurity regions IM1 and IM2. The first impurity regions IM1 of the peripheral active patterns PAP may be in contact with the first peripheral wiring line PI1. The second impurity regions IM2 of the peripheral active patterns PAP may be in contact with conductive patterns BP.

The third peripheral transistors PTR3 may include a third left peripheral transistor PTR3(L) and a third right peripheral transistor PTR3(R). The third left peripheral transistor PTR3(L) and the third right peripheral transistor PTR3(R) may constitute a third pair transistor structure PTS3.

A material included in each of the first and second gate dielectric layers Gox1 and Gox2 of the third pair transistor structure PTS3 of FIG. 7B may be the same as or different from a material included in each of the first and second gate dielectric layers Gox1 and Gox2 of the cell transistor structure CTS of FIG. 5A. The first gate dielectric layers Gox1 of the third pair transistor structure PTS3 may have a fifth thickness T5. The second gate dielectric layers Gox2 of the third pair transistor structure PTS3 may have a sixth thickness T6. The fifth thickness T5 of FIG. 7B may be the same as or different from the third thickness T3 of FIG. 6 and the first thickness T1 of FIG. 5A, for example, the fifth thickness T5 may be the same as the first thickness T1. The sixth thickness T6 of FIG. 7B may be the same as or different from the fourth thickness T4 of FIG. 6 and the second thickness T2 of FIG. 5A, for example, the sixth thickness T6 may be the same as the second thickness T2.

To distinguish the first and second gate dielectric layers Gox1 and Gox2 of FIG. 5A from the first and second gate dielectric layers Gox1 and Gox2 of FIGS. 6 and 7B, the first and second gate dielectric layers Gox1 and Gox2 of FIG. 5A may be called first and second cell gate dielectric layers Gox1(C) and Gox2(C), and the first and second gate dielectric layers Gox1 and Gox2 of FIGS. 6 and 7B may be called first and second peripheral gate dielectric layers Gox1(P) and Gox2(P).

Referring to FIG. 7A, the second peripheral circuit section PE(2) may include the peripheral capacitor CAP2 connected to one of the third peripheral transistors PTR3. The peripheral capacitor CAP2 may be called a power capacitor. The peripheral capacitor CAP2 may include an electrode pad EP, bottom electrodes BE, a dielectric layer DL, and a top electrode UE. The peripheral capacitor CAP2 may also have an inverse structure. For example, the bottom electrodes BE may be positioned above the top electrode UE. The electrode pad EP may connect all of top surfaces of the bottom electrodes BE. The electrode pad EP and the bottom electrodes BE connected thereto may serve as a single electrode of the peripheral capacitor CAP2. With the electrode pad EP, sub-capacitors formed between the upper electrode UE and each of the bottom electrodes BE may be connected with each other in parallel.

In a semiconductor device according to the present embodiment, as the peripheral transistors PTR1 to PTR3 have their VCT structure, the peripheral transistors PTR1 to PTR3 may decrease in horizontal size. Thus, the peripheral structure PS may have a reduced horizontal area. In addition, the VCT structure of the peripheral transistors PTR1 to PTR3 may facilitate wiring routing and may reduce a connection distance between the cell structure CS and the peripheral structure PS.

A planar transistor may require a semiconductor substrate, but a VCT structured peripheral transistor may not need a semiconductor substrate. Thus, the peripheral structure PS may have a reduced vertical size. Moreover, a through via penetrating a semiconductor substrate may not be included, and thus a semiconductor device may have a reduced horizontal size. Accordingly, a semiconductor device may become highly integrated.

In this description, the cell transistors CTR are illustrated to have their VCT structure, but the present inventive concepts are not limited thereto. The cell transistors CTR may have their buried channel array transistor (BCAT) structure.

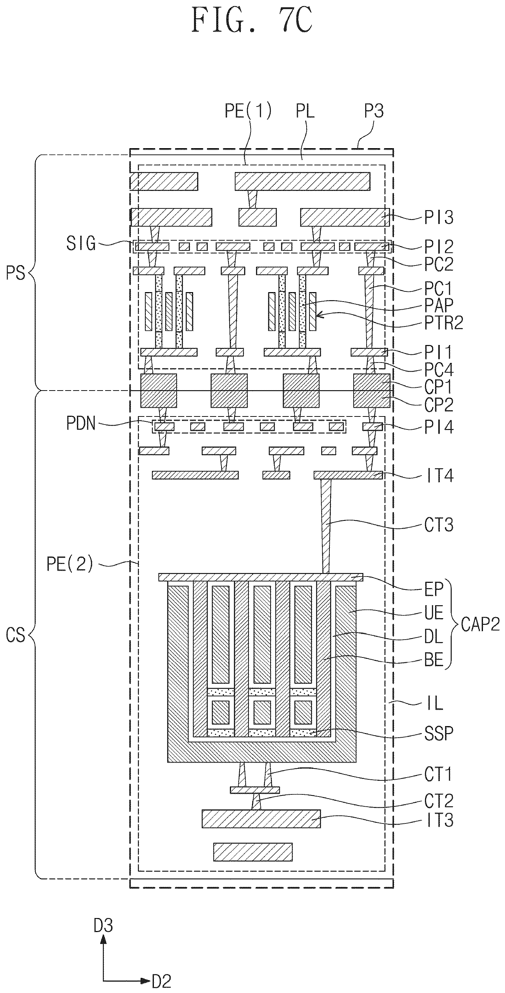

FIG. 7C illustrates an enlarged view showing section P3 of FIG. 3 according to an embodiment of the present disclosure.

Referring to FIG. 7C, the second peripheral circuit section PE(2) may not include but exclude the third peripheral transistors PTR3. One of the third cell contact plugs CT3 may connect the electrode pad EP to one of the fourth cell wiring lines IT4. Other configurations may be identical or similar to those discussed above.

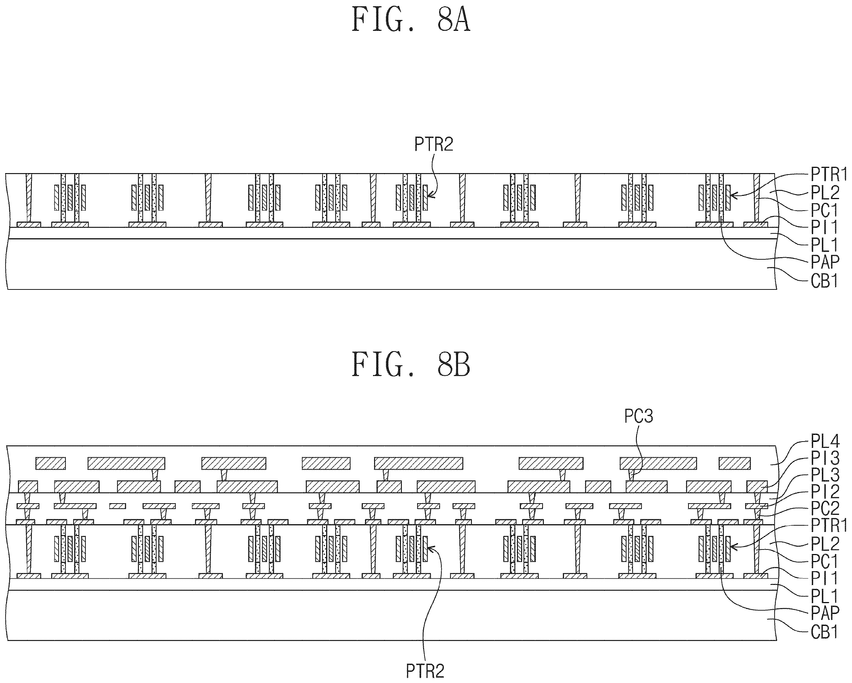

FIGS. 8A to 8J illustrate cross-sectional views showing a method of fabricating a semiconductor device of FIG. 3.

Referring to FIG. 8A, a first peripheral interlayer dielectric layer PL1 may be formed on a first carrier substrate CB1. First peripheral wiring lines PI1, first and second peripheral transistors PTR1 and PTR2, first peripheral contact plugs PC1, and a second peripheral interlayer dielectric layer PL2 may be formed on the first peripheral interlayer dielectric layer PL1.

Referring to FIG. 8B, second peripheral contact plugs PC2, second peripheral wiring lines PI2, and a third peripheral interlayer dielectric layer PL3 may be formed on the second peripheral interlayer dielectric layer PL2. Third peripheral contact plugs PC3, third peripheral wiring lines PI3, and a fourth peripheral interlayer dielectric layer PL4 may be formed on the third peripheral interlayer dielectric layer PL3.

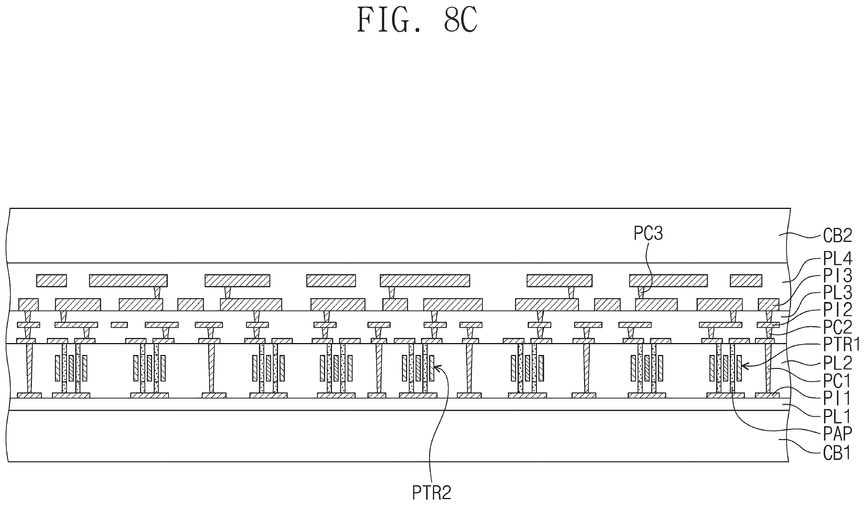

Referring to FIG. 8C, a second carrier substrate CB2 may be bonded to the fourth peripheral interlayer dielectric layer PL4.

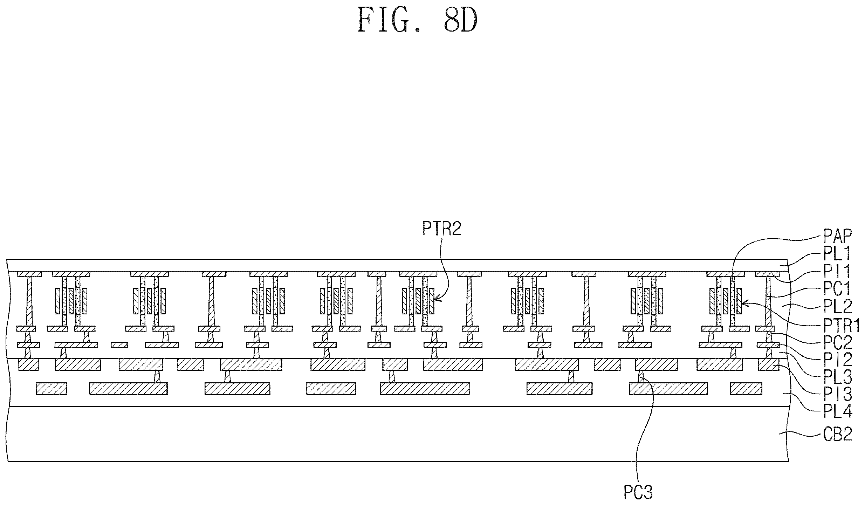

Referring to FIG. 8D, the first carrier substrate CB1 of FIG. 8C may be removed to expose a bottom surface of the first peripheral interlayer dielectric layer PL1. A resultant structure may be turned upside down to allow the bottom surface of the first peripheral interlayer dielectric layer PL1 to face upwards.

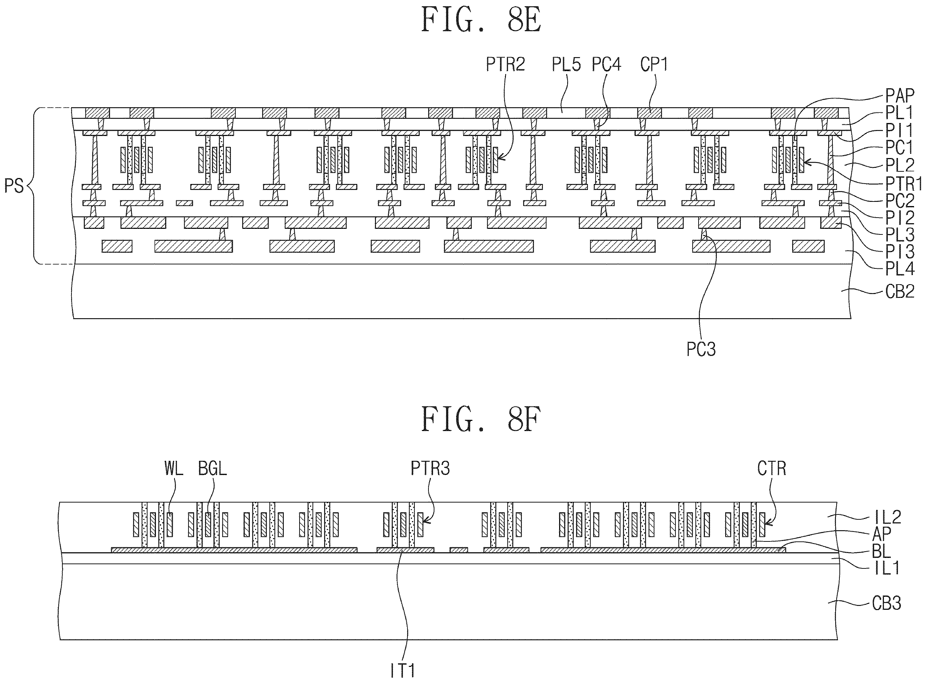

Referring to FIG. 8E, fourth peripheral contact plugs PC4 may be formed in the first peripheral interlayer dielectric layer PL1. A fifth peripheral interlayer dielectric layer PL5 may be formed on the first peripheral interlayer dielectric layer PL1. Peripheral connection pads CP1 may be formed in the fifth peripheral interlayer dielectric layer PL5. Thus, a peripheral structure PS may be manufactured on the second carrier substrate CB2.

Referring to FIG. 8F, a first cell interlayer dielectric layer IL1 may be formed on a third carrier substrate CB3. Bit lines BL, first cell wiring lines IT1, active patterns AP, cell transistors CTR, third peripheral transistors PTR3, and a second cell interlayer dielectric layer IL2 may be formed on the first cell interlayer dielectric layer IL1.

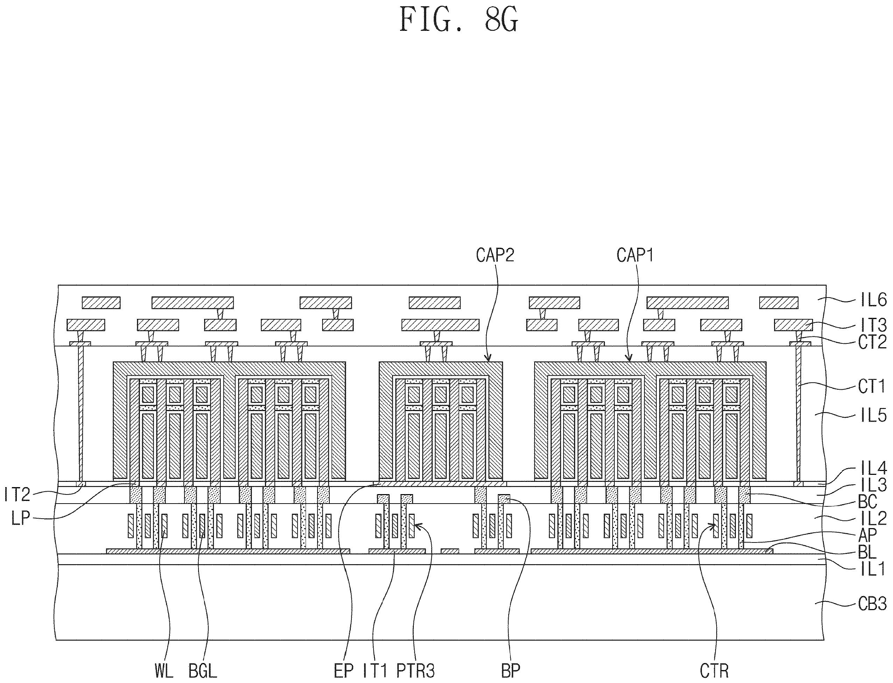

Referring to FIG. 8G, a third cell interlayer dielectric layer IL3 may be formed on the second cell interlayer dielectric layer IL2. Storage node contacts BC and conductive patterns BP may be formed in the third cell interlayer dielectric layer IL3. A fourth cell interlayer dielectric layer IL4, landing pads LP, second cell wiring lines IT2, and an electrode pad EP may be formed on the third cell interlayer dielectric layer IL3. Cell capacitors CAP1 and a peripheral capacitor CAP2 may be formed on the fourth cell interlayer dielectric layer IL4. A fifth cell interlayer dielectric layer IL5 may be formed to cover the cell capacitors CAP1 and the peripheral capacitor CAP2. First cell contact plugs CT1 may be formed to penetrate the fifth cell interlayer dielectric layer IL5. Second cell contact plugs CT2, third cell wiring lines IT3, and a sixth cell interlayer dielectric layer IL6 may be formed on the fifth cell interlayer dielectric layer IL5.

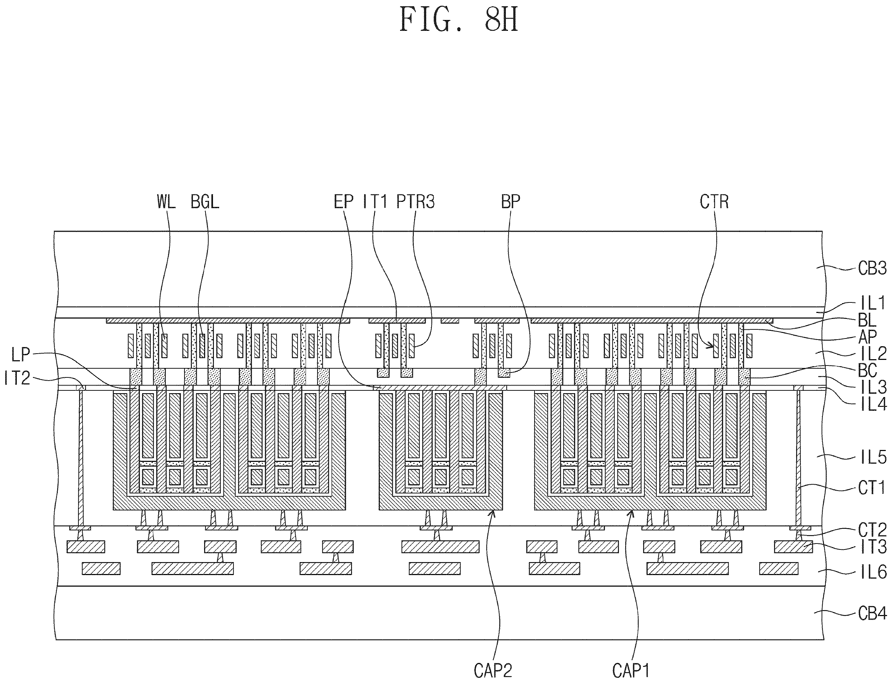

Referring to FIG. 8H, a fourth carrier substrate CB4 may be bonded to the sixth cell interlayer dielectric layer IL6 in a state depicted in FIG. 8G. A resultant structure may be turned upside down to allow the third carrier substrate CB3 to face upwards.

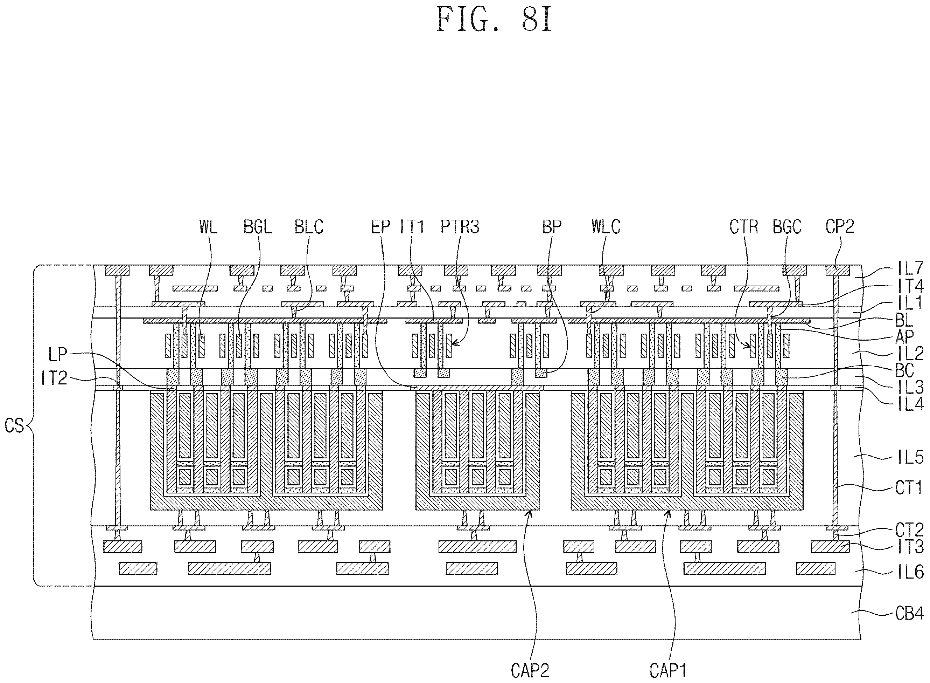

Referring to FIG. 8I, the third carrier substrate CB3 of FIG. 8H may be removed to expose a top surface of the first cell interlayer dielectric layer IL1. Bit-line contact plugs BLC, word-line contact plugs WLC, and back gate contact plugs BGC may be formed to penetrate the first cell interlayer dielectric layer IL1. Fourth cell wiring lines IT4, a seventh cell interlayer dielectric layer IL7, and cell connection pads CP2 may be formed on the first cell interlayer dielectric layer IL1. Thus, a cell structure CS may be manufactured on the fourth carrier substrate CB4.

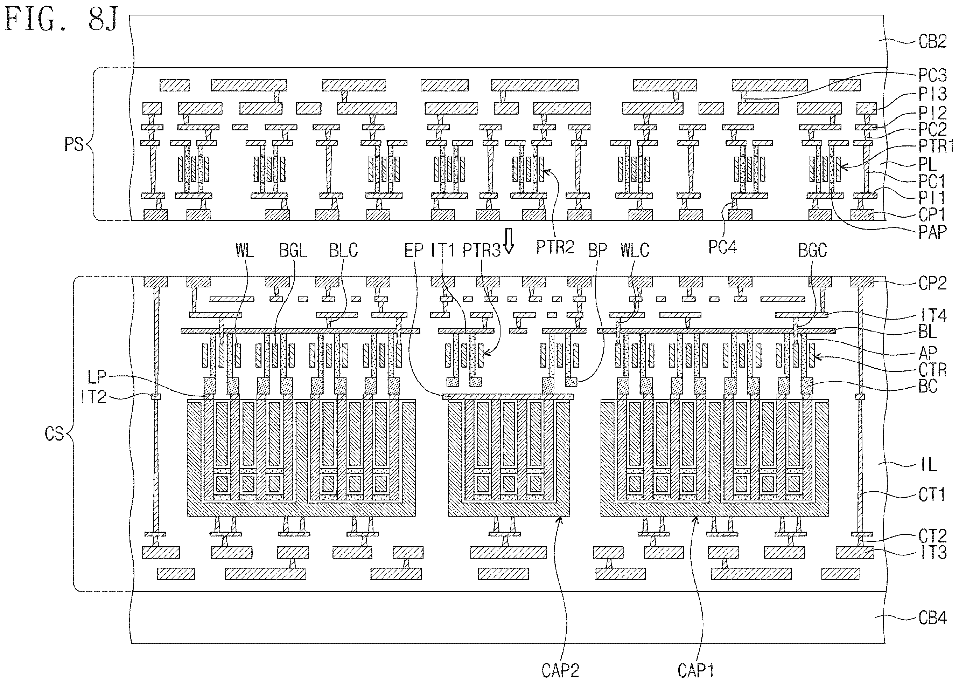

Referring to FIG. 8J, the peripheral structure PS of FIG. 8E may be flipped and placed on the cell structure CS of FIG. 8I. A thermocompression process may be performed to bond the peripheral structure PS to the cell structure CS. For simplification of drawings, the first to fifth peripheral interlayer dielectric layers PL1 to PL5 of FIG. 8E may be integrated and represented as a peripheral interlayer dielectric layer PL in FIG. 8J. Likewise, for simplification of drawings, the first to seventh cell interlayer dielectric layers IL1 to IL7 of FIG. 8I may be integrated and represented as a cell interlayer dielectric layer IL in FIG. 8J.

Referring to FIG. 3, after the bonding of the peripheral structure PS to the cell structure CS, the second carrier substrate CB2 of FIG. 8J may be removed. The fourth carrier substrate CB4 of FIG. 8J may become a substrate 100 of FIG. 3. A semiconductor device may thus be fabricated as shown in FIG. 3.

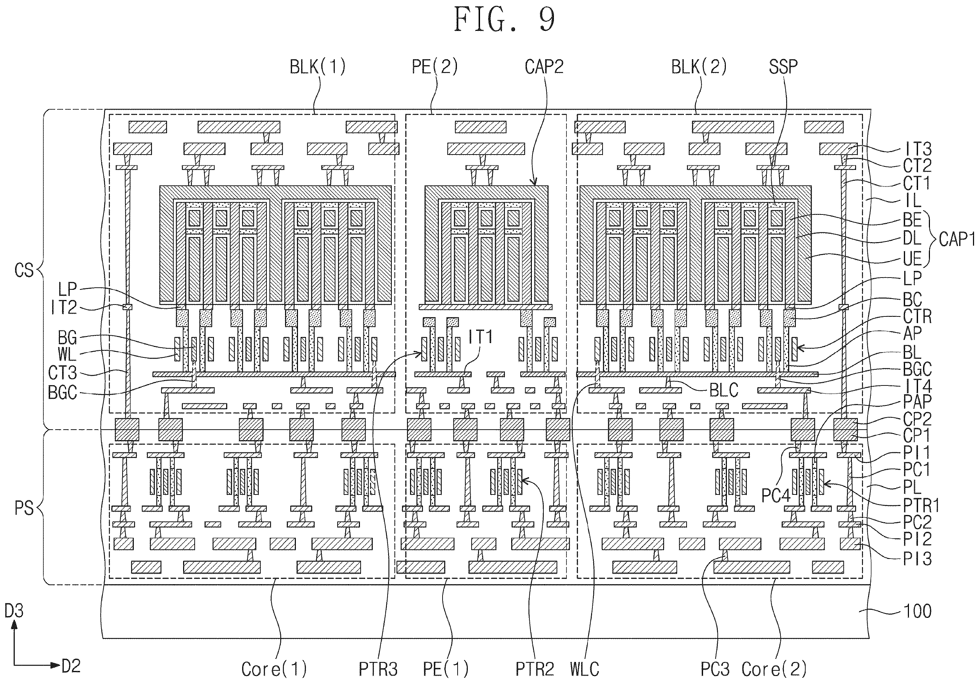

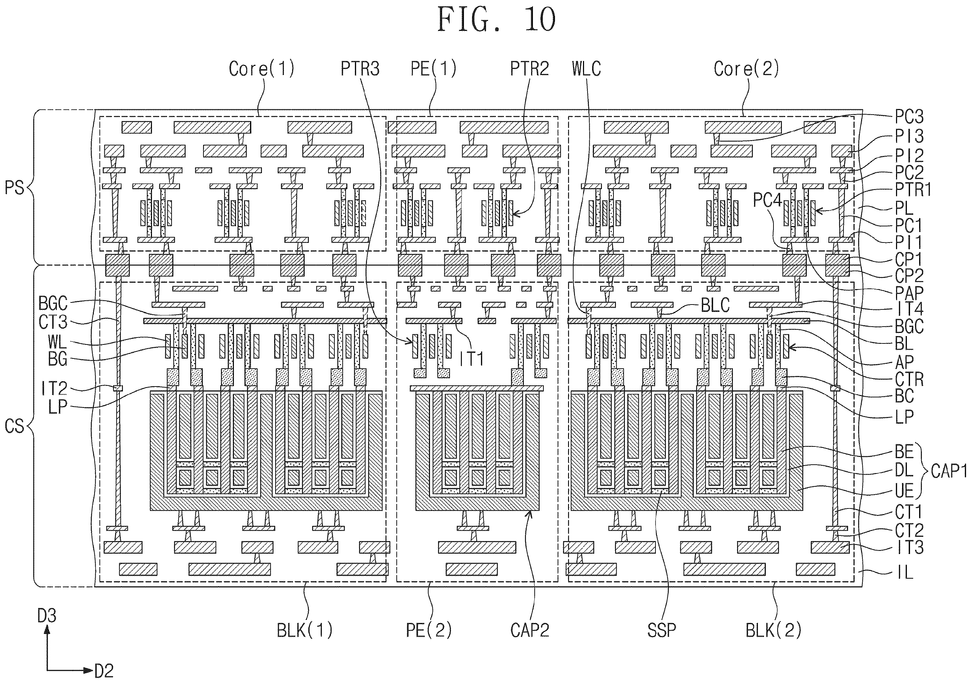

FIGS. 9 and 10 illustrate cross-sectional views showing a semiconductor device according to some embodiments of the present inventive concepts.

A semiconductor device of FIG. 9 may include a peripheral structure PS and a cell structure CS that are sequentially stacked on a substrate 100. The peripheral structure PS and the cell structure CS of FIG. 9 may have configurations obtained by flipping those of the peripheral structure PS and the cell structures CS of FIG. 3 on the substrate 100. Other configurations may be identical to those of FIG. 3. The semiconductor device of FIG. 9 may be fabricated by employing a thermocompression process to bond the peripheral structure PS and the cell structure CS with each other as shown in FIG. 8J, removing the fourth carrier substrate CB4, and then flipping a resultant structure. The second carrier substrate CB2 of FIG. 8J may become a substrate 100 of FIG. 3.

A semiconductor device of FIG. 10 may not include a substrate 100, and may include a cell structure CS and a peripheral structure PS that are sequentially stacked. Other configurations may be identical to those of FIG. 3. The semiconductor device of FIG. 10 may be fabricated by employing a thermocompression process to bond the peripheral structure PS and the cell structure CS with each other as shown in FIG. 8J, and then removing both of the second carrier substrate CB2 and the fourth carrier substrate CB4.

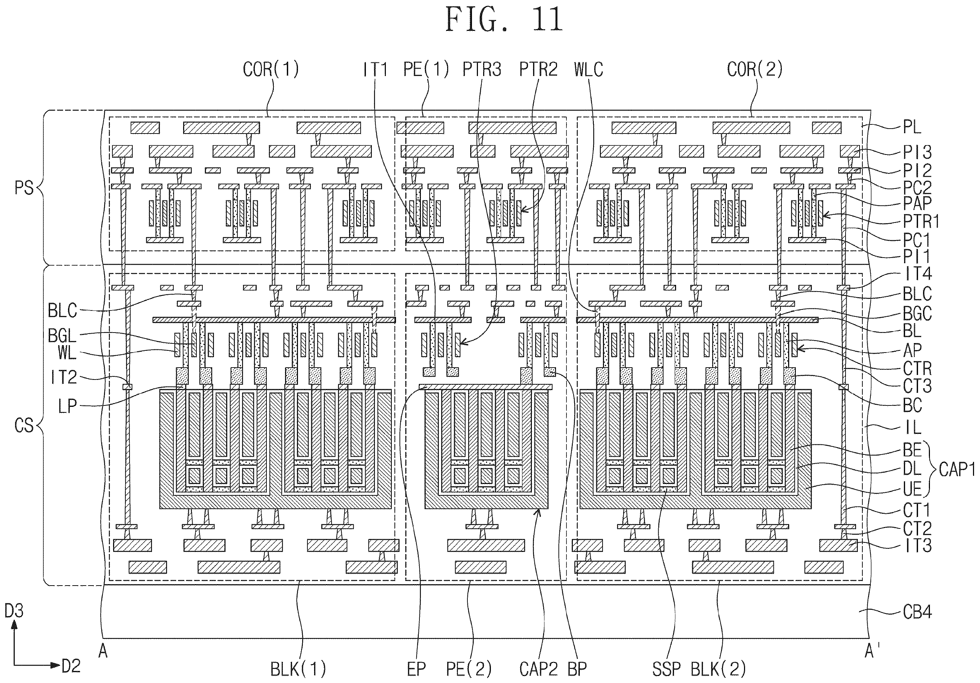

FIG. 11 illustrates a cross-sectional view taken along line A-A' of FIG. 2 according to an embodiment of the present disclosure.

Referring to FIG. 11, a semiconductor device according to the present embodiment may not include but exclude the peripheral connection pads CP1 and the cell connection pads CP2 of FIG. 3. The cell interlayer dielectric layer IL may have a top surface in direct contact with a bottom surface of a peripheral interlayer dielectric layer PL. The first peripheral contact plug PC1 may penetrate portions of the cell interlayer dielectric layer IL and the peripheral interlayer dielectric layer PL to connect the second peripheral wiring line PI2 to the fourth cell wiring line IT4. Other configurations may be identical or similar to those discussed with reference to FIGS. 3 to 7B.

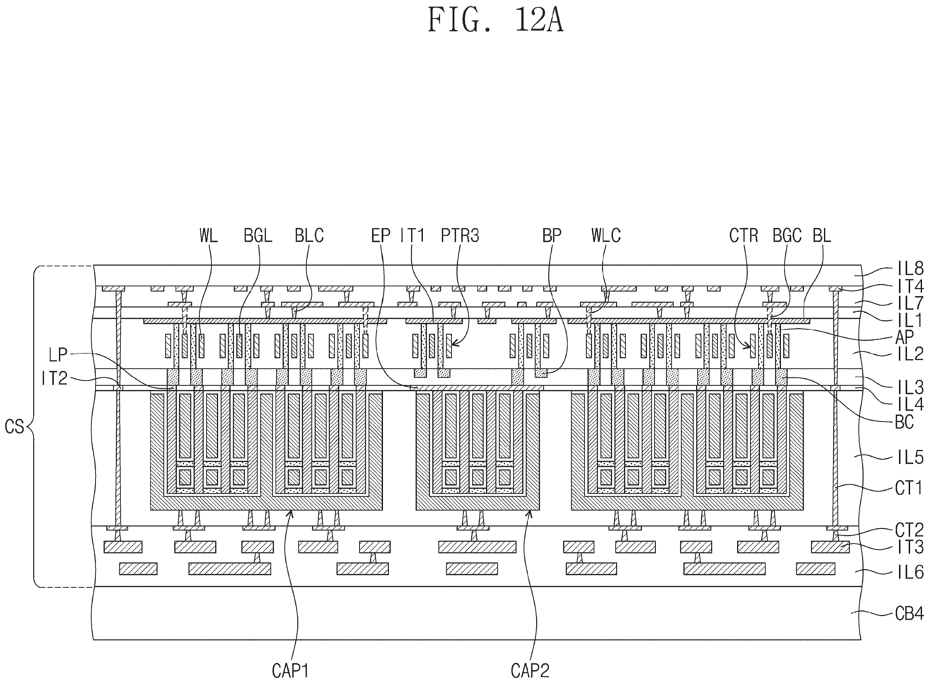

FIGS. 12A to 12E illustrate cross-sectional views showing a method of fabricating the semiconductor device of FIG. 11 according to an embodiment of the present disclosure.

Referring to FIG. 12A, the third carrier substrate CB3 of FIG. 8H may be removed to expose the first cell interlayer dielectric layer IL1. A bit-line contact plug BLC, a back gate contact plug BGC, and a word-line contact plug WLC may be formed in the first cell interlayer dielectric layer IL1. A seventh cell interlayer dielectric layer IL7, a fourth cell wiring line IT4, and third cell contact plugs CT3 may be formed on the first cell interlayer dielectric layer IL1. An eighth cell interlayer dielectric layer IL8 may be formed on the seventh cell interlayer dielectric layer IL7. Thus, a cell structure CS may be manufactured on the fourth carrier substrate CB4.

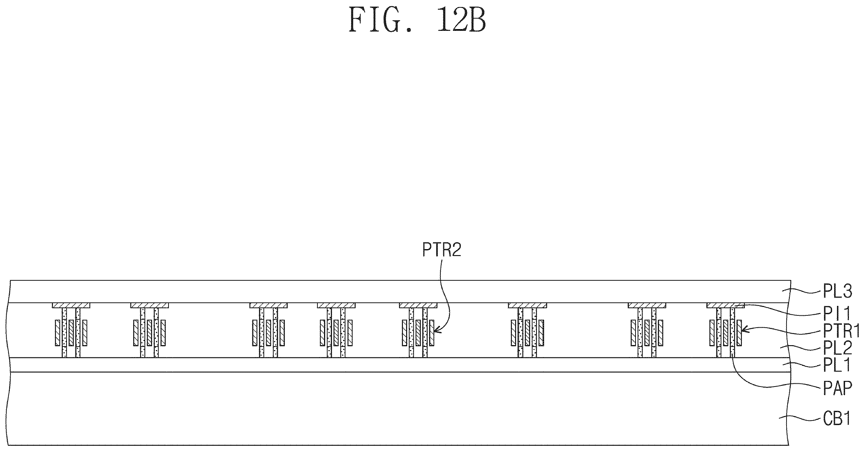

Referring to FIG. 12B, a first peripheral interlayer dielectric layer PL1 may be formed on the first carrier substrate CB1. A second peripheral interlayer dielectric layer PL2, peripheral active patterns PAP, first peripheral wiring lines PI1, and first and second peripheral transistors PTR1 and PTR2 may be formed on the first peripheral interlayer dielectric layer PL1. A third peripheral interlayer dielectric layer PL3 may be formed on the second peripheral interlayer dielectric layer PL2.

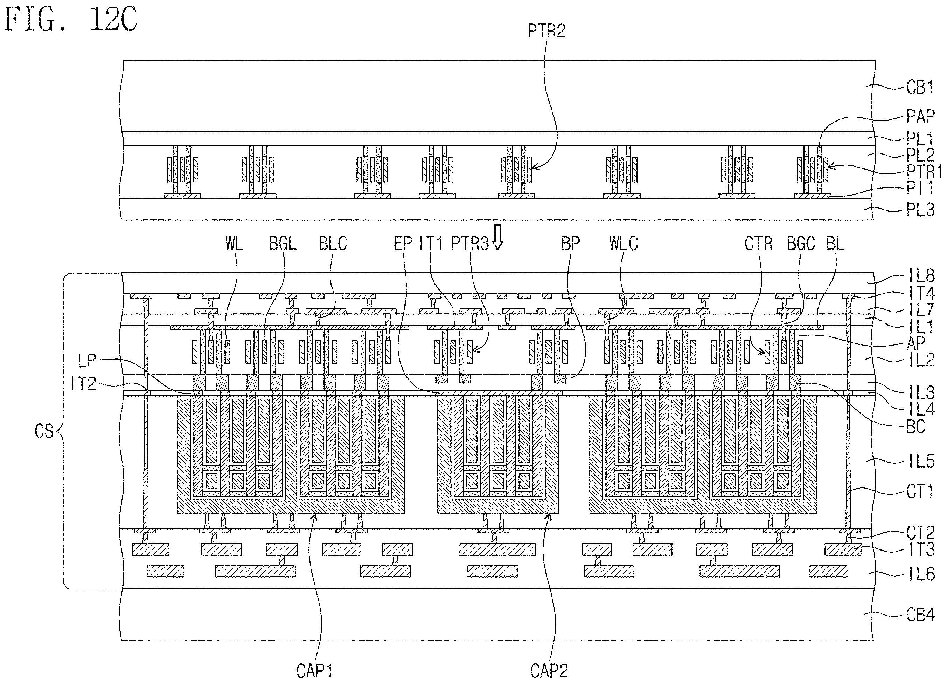

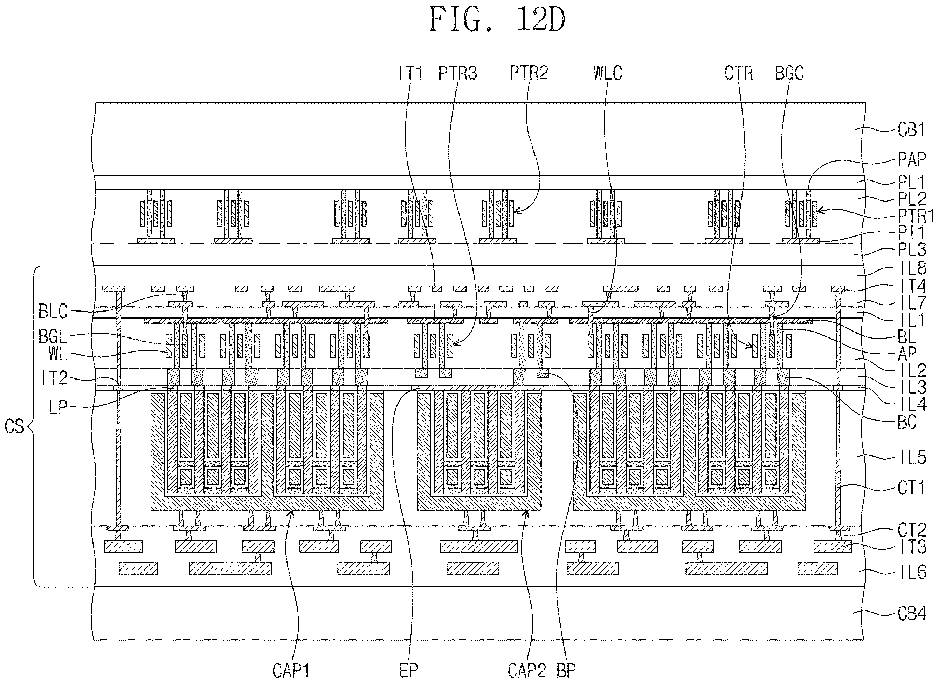

Referring to FIGS. 12C and 12D, a structure of FIG. 12B may be flipped and placed on the cell structure CS of FIG. 12A. Thus, the third peripheral interlayer dielectric layer PL3 may be in contact with the eighth cell interlayer dielectric layer IL8 of the cell structure CS. A thermocompression process may be performed to bond the third peripheral interlayer dielectric layer PL3 to the eighth cell interlayer dielectric layer IL8.

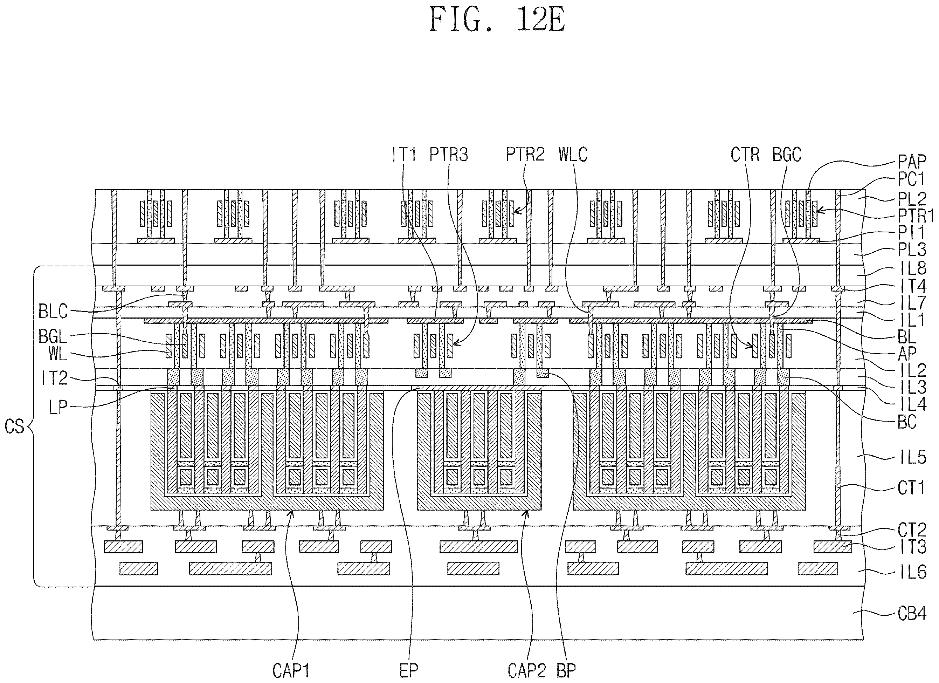

Referring to FIG. 12E, the first carrier substrate CB1 and the first peripheral interlayer dielectric layer PL1 on the second peripheral interlayer dielectric layer PL2 may be removed to expose the peripheral active patterns PAP. First peripheral contact plugs PC1 may be formed to penetrate the second peripheral interlayer dielectric layer PL2, the third peripheral interlayer dielectric layer PL3, and the eighth cell interlayer dielectric layer IL8, thereby being in contact with the fourth cell wiring lines IT4.

Referring to FIG. 11, second peripheral wiring lines PI2, the second peripheral contact plugs PC2, third peripheral wiring lines PI3, third peripheral contact plugs PC3, and additional peripheral interlayer dielectric layers may be formed on the second peripheral interlayer dielectric layer PL2. A semiconductor device may thus be fabricated as shown in FIG. 11. For simplification of drawings, the first to third peripheral interlayer dielectric layers PL1 to PL3 of FIG. 12E may be integrated and represented as a peripheral interlayer dielectric layer PL in FIG. 11. Likewise, for simplification of drawings, the first to eighth cell interlayer dielectric layers IL1 to IL8 of FIG. 12E may be integrated and represented as a cell interlayer dielectric layer IL in FIG. 11.

The following description will focus on various configurations of a pair of transistor structures including peripheral transistors according to the present inventive concepts. A pair of transistor structures PTS according to the present inventive concepts may be used as a basic unit to constitute various circuits.

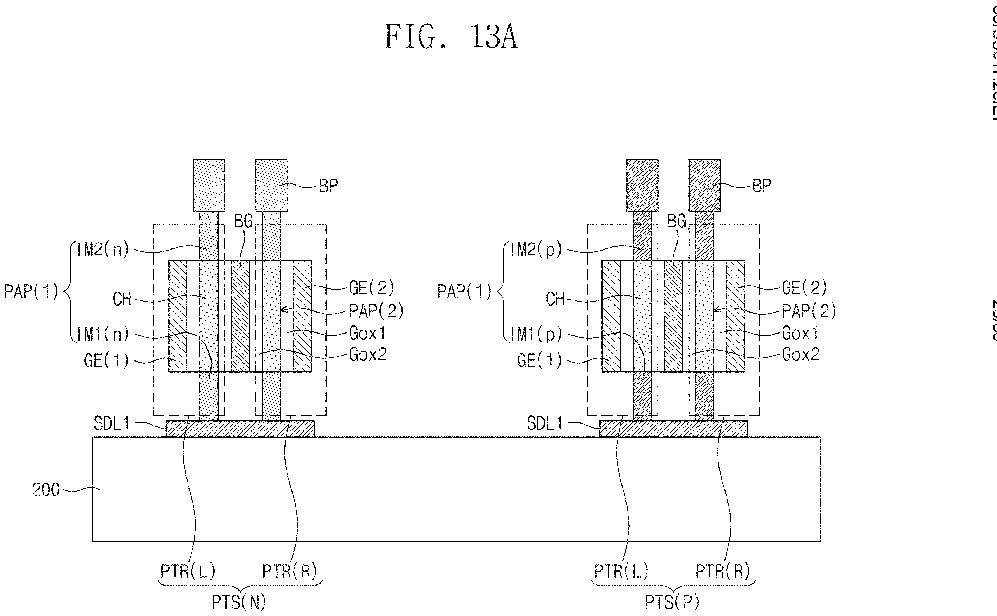

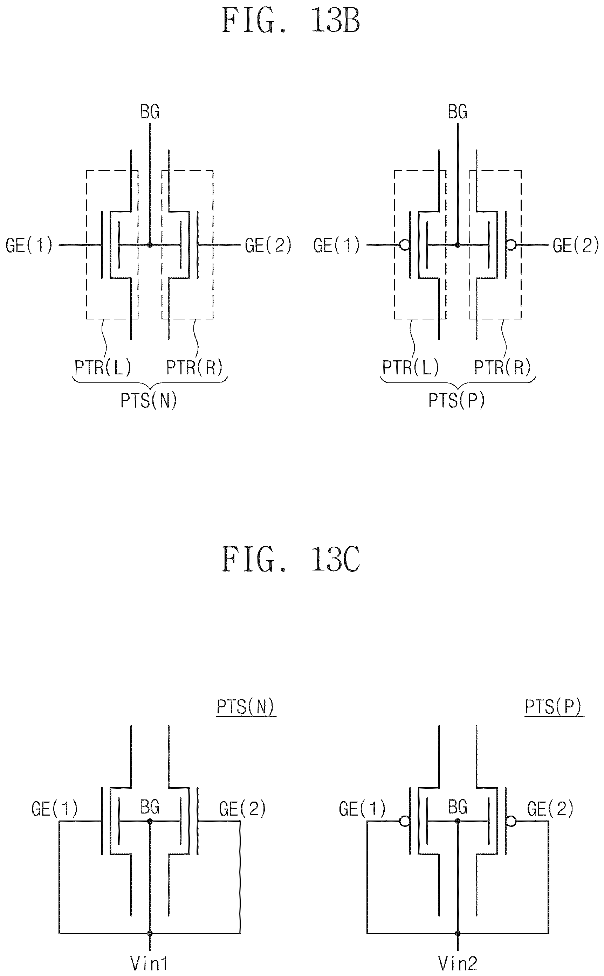

FIG. 13A illustrates a cross-sectional view showing a semiconductor device according to some embodiments of the present inventive concepts. FIGS. 13B to 13D illustrate circuit diagrams showing a semiconductor device that has a structure of FIG. 13A.

Referring to FIG. 13A, a pair of N-type transistor structure PTS(N) (i.e., the N-type pair transistor structure PTS(N)) and a pair of P-type transistor structure PTS(P) (i.e., P-type pair transistor structure PTS(P)) may be disposed on a lower structure 200. The lower structure 200 may be a semiconductor substrate, a dielectric substrate, a conductive layer, or a dielectric layer. The N-type pair transistor structure PTS(N) and the P-type pair transistor structure PTS(P) may each include a pair of left and right peripheral transistors PTR(L) and PTR(R) that are adjacent to each other. Each of the left peripheral transistor PTR(L) and the right peripheral transistor PTR(R) may include a peripheral active pattern PAP and a peripheral gate electrode GE. The peripheral active pattern PAP may include a channel region CH and first and second impurity regions IM1 and IM2.

In this description, the first impurity region IM1 may correspond to a drain or a source of one of the left peripheral transistor PTR(L) and the right peripheral transistor PTR(R), and may be called a first terminal. The second impurity region IM2 may correspond to a source or a drain of one of the left peripheral transistor PTR(L) and the right peripheral transistor PTR(R), and may be called a second terminal.

N-type impurities may be doped in the first and second impurity regions IM1 and IM2 included in the N-type pair transistor structure PTS(N). No impurities or P-type impurities may be doped in the channel region CH included in the N-type pair transistor structure PTS(N). P-type impurities may be doped in the first and second impurity regions IM1 and IM2 included in the P-type pair transistor structure PTS(P). No impurities or N-type impurities may be doped in the channel region CH included in the P-type pair transistor structure PTS(P).

First and second peripheral gate electrodes GE(1) and GE(2) of each of the N-type pair transistor structure PTS(N) and the P-type pair transistor structure PTS(P) may include metal, such as tungsten, aluminum, and copper. The first and second peripheral gate electrodes GE(1) and GE(2) of each of the N-type pair transistor structure PTS(N) and the P-type pair transistor structure PTS(P) may further include a work-function pattern suitable to each characteristics. In some embodiments, the work-function pattern may be included to control a threshold voltage of a transistor.

The first and second peripheral gate electrodes GE(1) and GE(2) included in the N-type pair transistor structure PTS(N) may include or may be formed of the same material and structure as those of the first and second peripheral gate electrodes GE(1) and GE(2) included in the P-type pair transistor structure PTS(P). In some embodiments, the first and second peripheral gate electrodes GE(1) and GE(2) included in the N-type pair transistor structure PTS(N) may include or may include different material and structure from those of the first and second peripheral gate electrodes GE(1) and GE(2) included in the P-type pair transistor structure PTS(P).

A conductive pattern BP may be disposed on the second impurity region IM2 of the peripheral active pattern PAP. The conductive pattern BP may include or may be formed of metal. In some embodiments, the conductive pattern BP may be formed of impurity-doped silicon, SiGe, or SiC. Impurities doped in the conductive pattern BP may have the same conductivity type as that of impurities doped in the second impurity region IM2 adjacent to the conductive pattern BP.

A source/drain connection line SDL1 may be disposed underneath the first impurity regions IM1 of the peripheral active patterns PAP that are adjacent to each other, and may connect the first impurity regions IM1 connected with each other. Each of the N-type pair transistor structure PTS(N) and the P-type pair transistor structure PTS(P) may further include a peripheral back gate electrode BG interposed between the peripheral active patterns PAP that are adjacent to each other.

Referring to FIGS. 13A and 13B, the N-type pair transistor structure PTS(N) may have a structure including two neighboring N-type metal oxide semiconductor (NMOS) transistors which have a VCT structure and share one back gate electrode. The P-type pair transistor structure PTS(P) may have a structure including two neighboring P-type metal oxide semiconductor (PMOS) transistors which have a VCT structure and share one back gate electrode. A semiconductor device of FIG. 13A may have a complementary metal oxide semiconductor (CMOS) transistor structure.

Referring to FIGS. 13A and 13C, the first and the second peripheral gate electrodes GE(1) and GE(2) and the peripheral back gate electrode BG of the N-type pair transistor structure PTS(N) may be connected to each other and provided with the same first input voltage Vin1. The first and the second peripheral gate electrodes GE(1) and GE(2) and the peripheral back gate electrode BG of the P-type pair transistor structure PTS(P) may be connected to each other and provided with the same second input voltage Vin2. In this case, each of the N-type pair transistor structure PTS(N) and the P-type pair transistor structure PTS(P) may have a double gate structure or a gate-all-around structure.

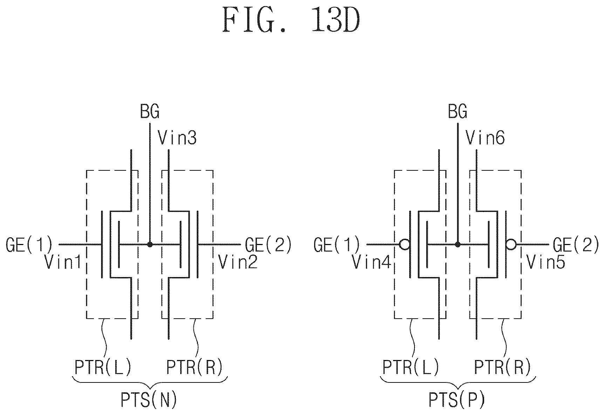

Referring to FIGS. 13A and 13D, the first and the second peripheral gate electrodes GE(1) and GE(2) and the peripheral back gate electrode BG of the N-type pair transistor structure PTS(N) may be provided with input voltages Vin1, Vin2, and Vin3 that are different from each other. The first and the second peripheral gate electrodes GE(1) and GE(2) and the peripheral back gate electrode BG of the P-type pair transistor structure PTS(P) may be provided with input voltages Vin4, Vin5, and Vin6 that are different from each other. In this case, each of the N-type pair transistor structure PTS(N) and the P-type pair transistor structure PTS(P) may have an independent double gate structure.

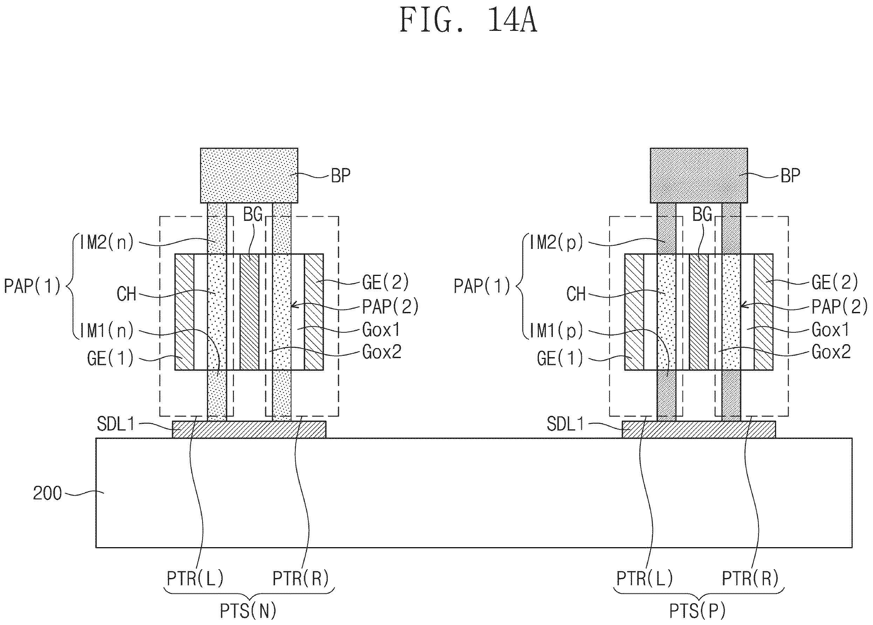

FIGS. 14A to 14D illustrate cross-sectional views showing a semiconductor device according to some embodiments of the present inventive concepts.

Referring to FIG. 14A, in the structure of FIG. 13A, the conductive pattern BP may be connected to each of the second impurity regions IM2 of the peripheral active patterns PAP that are adjacent to each other. Other configurations and circuitry may be identical or similar to those discussed with reference to FIGS. 13A to 13D.

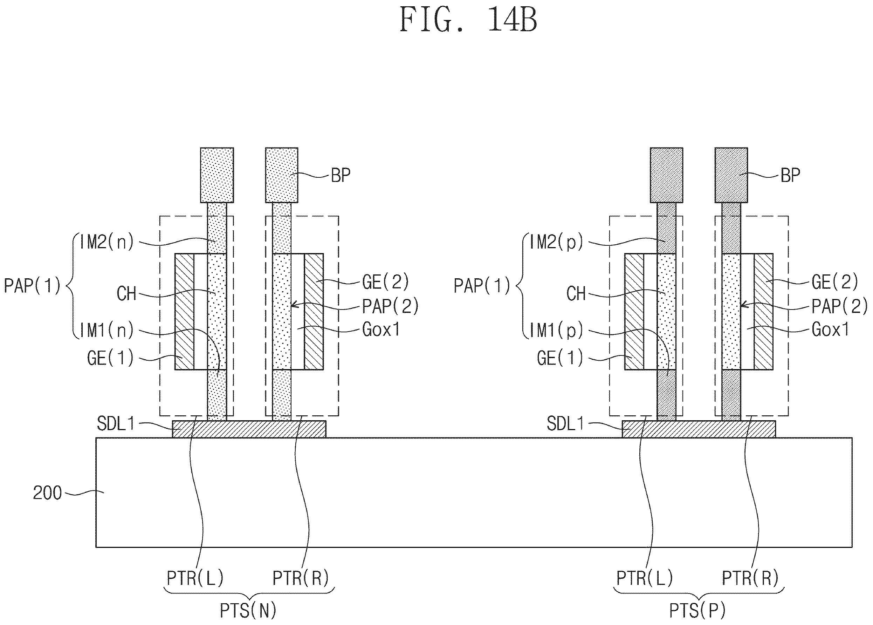

Referring to FIG. 14B, in the structure of FIG. 13A, the peripheral back gate electrode BG and the second gate dielectric layer Gox2 may be omitted.

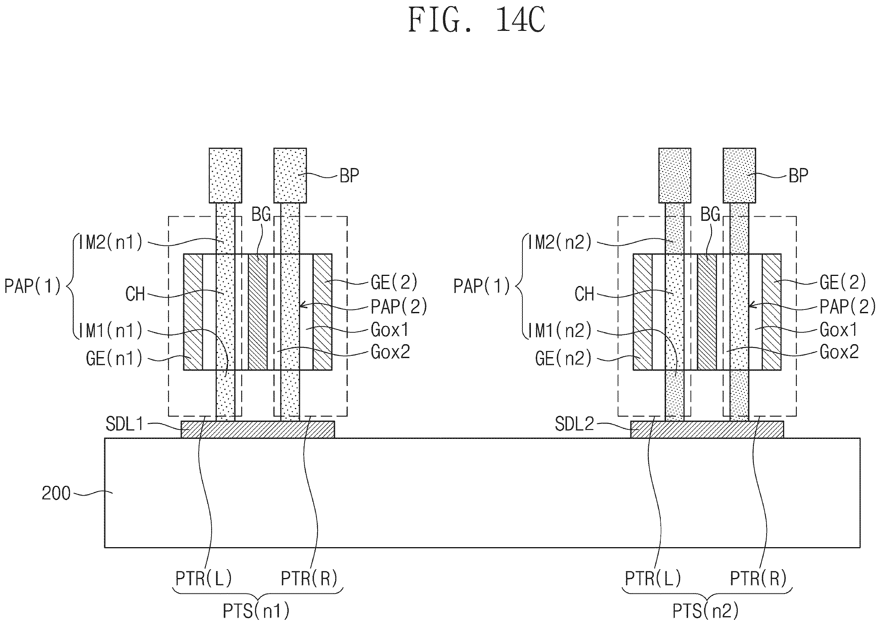

Referring to FIG. 14C, a first pair transistor structure PTS(n1) and a second pair transistor structure PTS(n2) may be disposed on the lower structure 200. Each of the first pair transistor structure PTS(n1) and the second pair transistor structure PTS(n2) may include a pair of left and right peripheral transistors PTR(L) and PTR(R) that are adjacent to each other. Each of the left peripheral transistor PTR(L) and the right peripheral transistor PTR(R) may include a peripheral active pattern PAP and a peripheral gate electrode GE. The peripheral active pattern PAP may include a channel region CH and first and second impurity regions IM1 and IM2.

First impurities having a first conductivity type may be doped in the first and second impurity regions IM1 and IM2 of each of the first pair transistor structure PTS(n1) and the second pair transistor structure PTS(n2). The first conductivity type may be N-type or P-type. The first and second impurity regions IM1 and IM2 of the first pair transistor structure PTS(n1) may be doped with the first impurities at a first concentration. The first and second impurity regions IM1 and IM2 of the second pair transistor structure PTS(n2) may be doped with the first impurities at a second concentration. The second concentration may be greater than the first concentration.

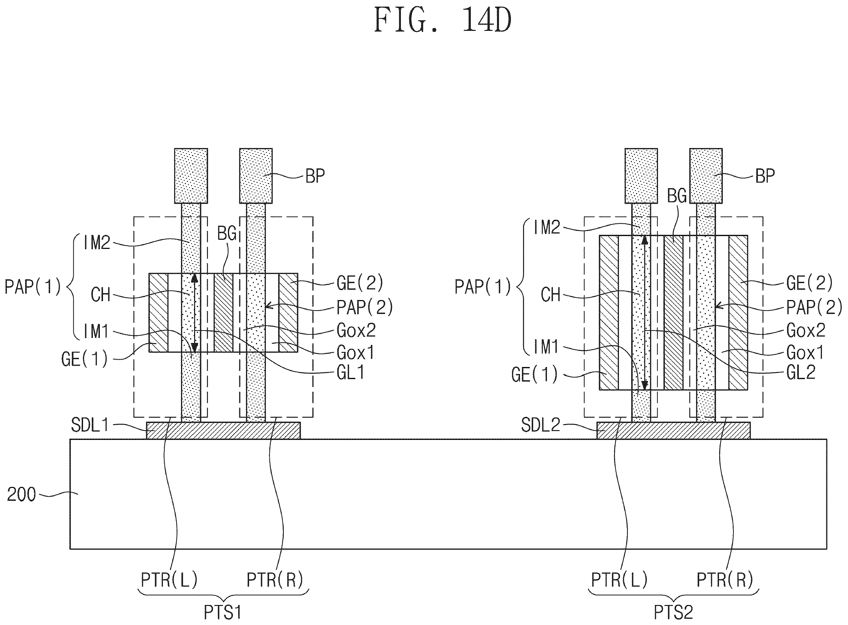

Referring to FIG. 14D, a first pair transistor structure PTS1 and a second pair transistor structure PTS2 may be disposed on the lower structure 200. The peripheral transistors PTR included in the first pair transistor structure PTS1 may have a first gate length GL1. The peripheral transistors PTR included in the second pair transistor structure PTS2 may have a second gate length GL2. The second gate length GL2 may be different from the first gate length GL1, and for example, the second gate length GL2 may be greater than the first gate length GL1. In this description, the term "gate length" may be defined to refer to a vertical length of a portion where the peripheral gate electrode GE and the channel region CH overlap each other horizontally.

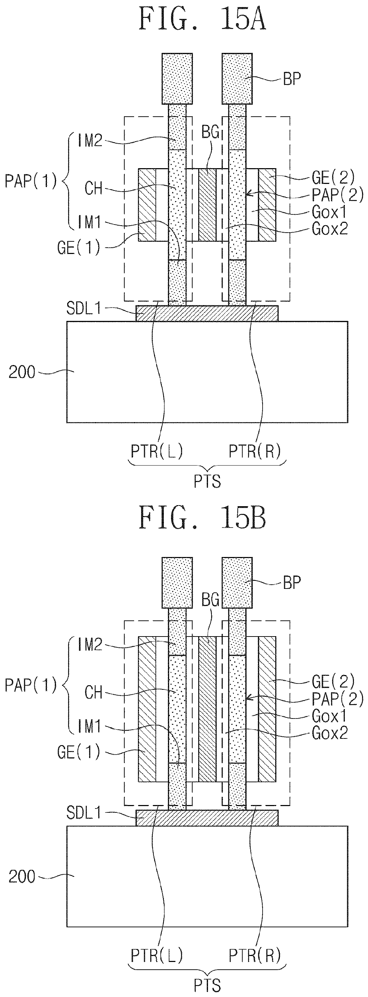

FIGS. 15A to 15E illustrate cross-sectional views showing a semiconductor device according to some embodiments of the present inventive concepts.

Referring to FIG. 15A, in a pair transistor structure PTS according to the present embodiment, the first and second peripheral gate electrodes GE(1) and GE(2) and the peripheral back gate electrodes BG may have a vertical length less than a vertical length of the channel region CH. Thus, the first and second impurity regions IM1 and IM2 may not horizontally overlap the peripheral back gate electrode BG and the first and second peripheral gate electrodes GE(1) and GE(2).

Referring to FIG. 15B, in a pair transistor structure PTS according to the present embodiment, the first and second peripheral gate electrodes GE(1) and GE(2) and the peripheral back gate electrodes BG may have a vertical length greater than a vertical length of the channel region CH. Thus, the first and second peripheral gate electrodes GE(1) and GE(2) and the peripheral back gate electrodes BG may horizontally overlap the first and second impurity regions IM1 and IM2.

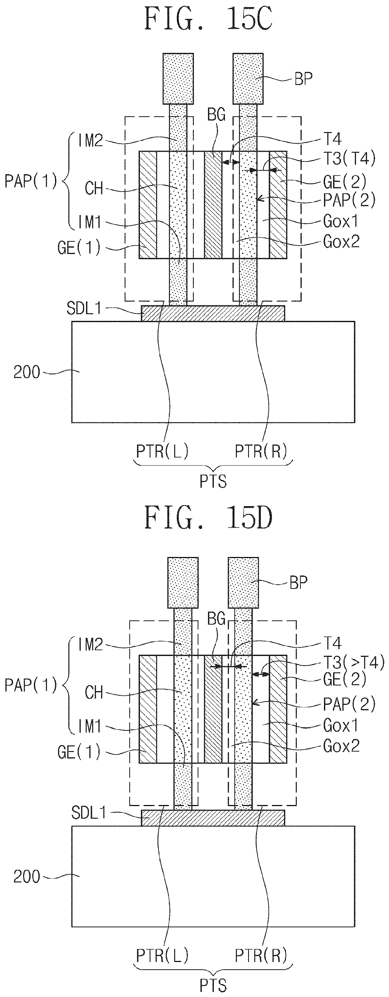

Referring to FIG. 15C, in a pair transistor structure PTS according to the present embodiment, the third thickness T3 of the first gate dielectric layer Gox1 may be less than the fourth thickness T4 of the second gate dielectric layer Gox2.

Referring to FIG. 15D, in a pair transistor structure PTS according to the present embodiment, the third thickness T3 of the first gate dielectric layer Gox1 may be greater than the fourth thickness T4 of the second gate dielectric layer Gox2.

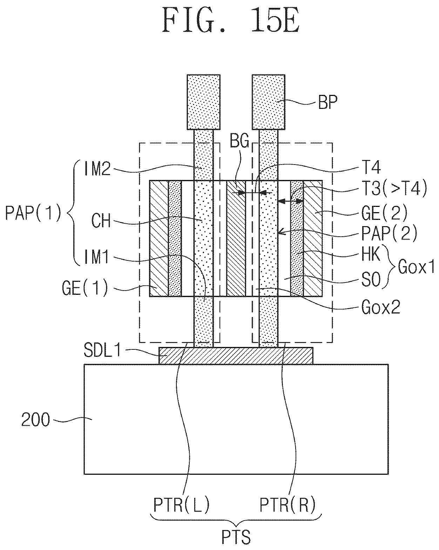

Referring to FIG. 15E, in a pair transistor structure PTS according to the present embodiment, the first gate dielectric layer Gox1 may be formed of a double layer including a silicon oxide layer SO and a high-k dielectric layer HK. The high-k dielectric layer HK may include a material, such as metal oxide, whose a dielectric constant is greater than a dielectric constant of the silicon oxide layer SO. The high-k dielectric layer HK may be interposed between the silicon oxide layer SO and the peripheral gate electrode GE. Other configurations may be identical or similar to those discussed above with reference to FIG. 15D.

In some embodiments, the first gate dielectric layer Gox1 may be formed of a single layer including the silicon oxide layer SO, and the second gate dielectric layer Gox2 may be formed of a double layer including the silicon oxide layer SO and the high-k dielectric layer HK.

Based on connection structures or operations of circuit, the peripheral back gate electrode BG may become a gate electrode, and each of the first and second peripheral gate electrodes GE(1) and GE(2) may become a back gate electrode. According to an embodiment, the first peripheral gate electrode GE(1), the peripheral back gate electrode BG, and the second peripheral gate electrode GE(2) may be called a first gate electrode, a second gate electrode, and a third gate electrode, respectively, according to the described order.

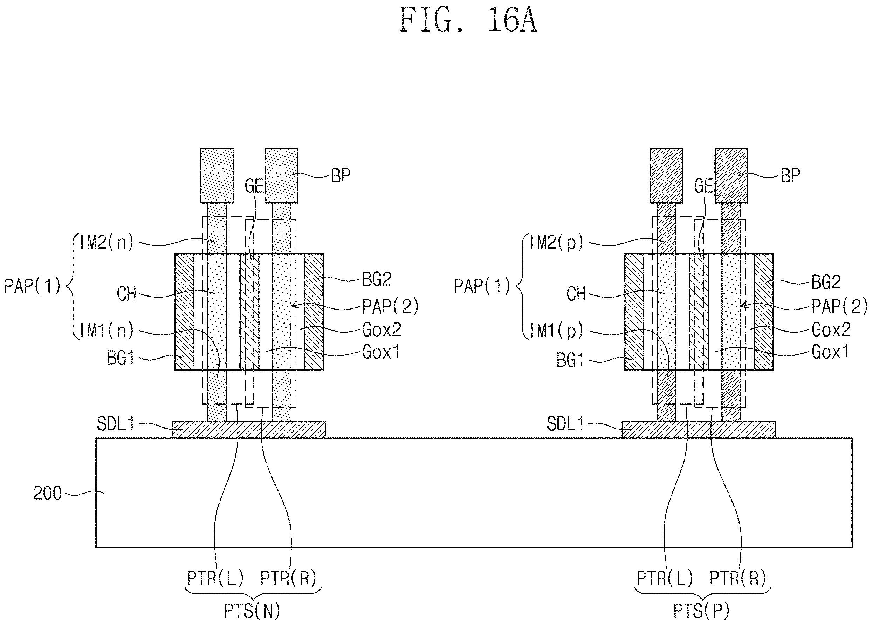

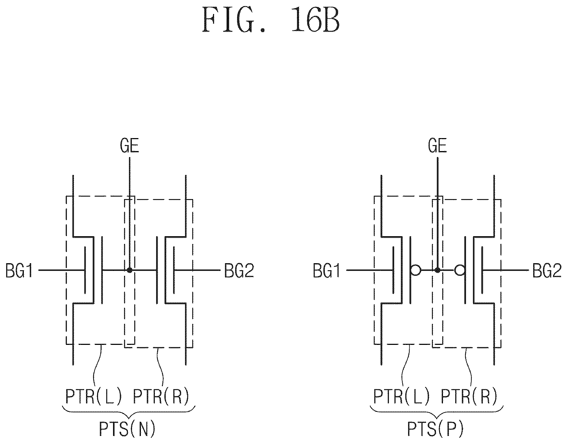

FIG. 16A illustrates a cross-sectional view showing a semiconductor device according to some embodiments of the present inventive concepts. FIG. 16B illustrates a circuit diagram showing a semiconductor device of FIG. 16A.

Referring to FIGS. 16A and 16B, an N-type pair transistor structure PTS(N) and a P-type pair transistor structure PTS(P) may be disposed on a lower structure 200. The N-type pair transistor structure PTS(N) and the P-type pair transistor structure PTS(P) may each include a pair of left and right peripheral transistors PTR(L) and PTR(R) that are adjacent to each other. Each of the left peripheral transistor PTR(L) and the right peripheral transistor PTR(R) may include a peripheral active pattern PAP. A peripheral gate electrode GE may be interposed between first and second peripheral active patterns PAP(1) and PAP(2) that are adjacent to each other. A first peripheral back gate electrode BG1 may be disposed on a left side of the first peripheral active pattern PAP(1). A second peripheral back gate electrode BG2 may be disposed on a right side of the second peripheral active pattern PAP(2). The left peripheral transistor PTR(L) and the right peripheral transistor PTR(R) may share the peripheral gate electrode GE. A threshold voltage of the left peripheral transistor PTR(L) may be adjusted by the first peripheral back gate electrode BG1. A threshold voltage of the right peripheral transistor PTR(R) may be adjusted by the second peripheral back gate electrode BG2.

N-type impurities may be doped in the first and second impurity regions IM1 and IM2 included in the N-type pair transistor structure PTS(N). No impurities or P-type impurities may be doped in the channel region CH included in the N-type pair transistor structure PTS(N). P-type impurities may be doped in the first and second impurity regions IM1 and IM2 included in the P-type pair transistor structure PTS(P). No impurities or N-type impurities may be doped in the channel region CH included in the P-type pair transistor structure PTS(P).

The N-type pair transistor structure PTS(N) may have a structure including two neighboring N-type metal oxide semiconductor (NMOS) transistors which have a VCT structure and share one peripheral gate electrode GE. The P-type pair transistor structure PTS(P) may have a structure including two neighboring P-type metal oxide semiconductor (PMOS) transistors which have a VCT structure and share one peripheral gate electrode GE.

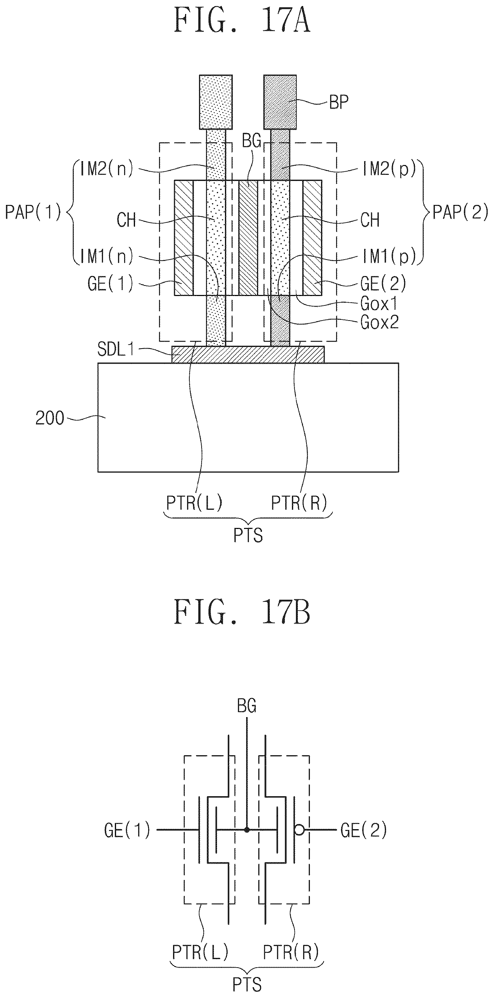

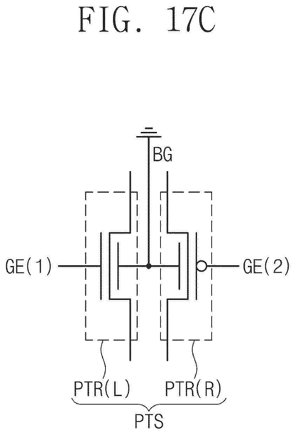

FIG. 17A illustrates a cross-sectional view showing a semiconductor device according to some embodiments of the present inventive concepts. FIGS. 17B and 17C illustrate circuit diagrams showing a semiconductor device of FIG. 17A.

Referring to FIGS. 17A and 17B, a pair transistor structure PTS according to the present embodiment may include a pair of left and right peripheral transistors PTR(L) and PTR(R) that are adjacent to each other. N-type impurities may be doped in a conductive pattern BP and first and second impurity regions IM1(n) and IM2(n) of the left peripheral transistor PTR(L). P-type impurities may be doped in a conductive pattern BP and first and second impurity regions IM1(p) and IM2(p) of the right peripheral transistor PTR(R). The left peripheral transistor PTR(L) may be a VCT structured NMOS transistor. The right peripheral transistor PTR(R) may be a VCT structured PMOS transistor. The left peripheral transistor PTR(L) and the right peripheral transistor PTR(R) may share one peripheral back gate electrode BG. The pair transistor structure PTS may have a CMOS transistor structure that shares a back gate electrode.

In FIG. 17C, the peripheral back gate electrode BG may be electrically grounded. In this case, a CMOS transistor structure may include a PMOS transistor and an NMOS transistor whose threshold voltages are low.

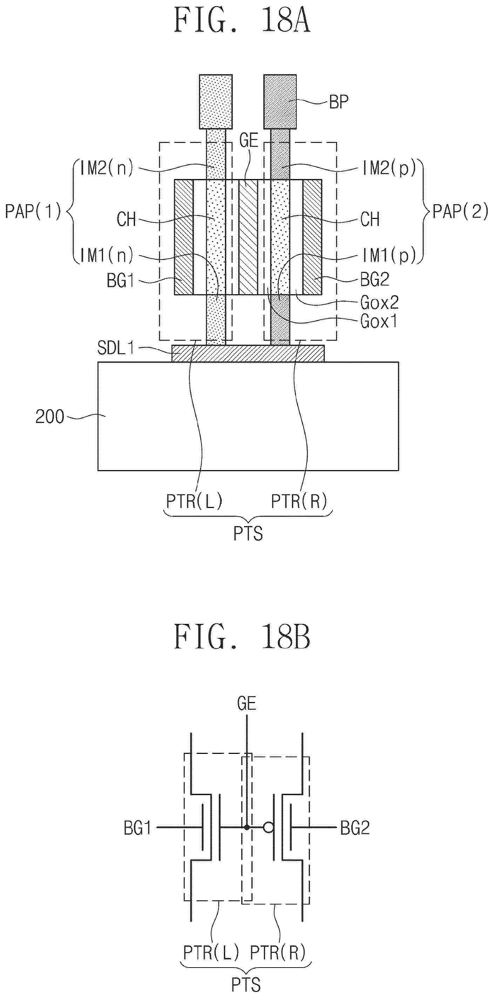

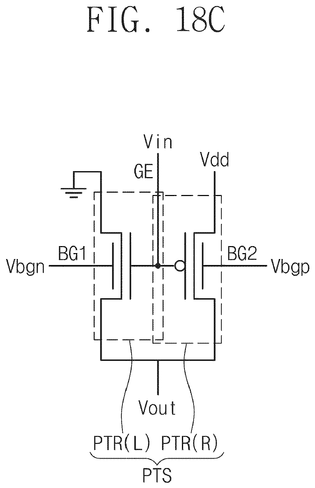

FIG. 18A illustrates a cross-sectional view showing a semiconductor device according to some embodiments of the present inventive concepts. FIGS. 18B and 18C illustrate circuit diagrams showing a semiconductor device of FIG. 18A.

Referring to FIGS. 18A and 18B, a pair transistor structure PTS according to the present embodiment may include a pair of left and right peripheral transistors PTR(L) and PTR(R) that are adjacent to each other. N-type impurities may be doped in a conductive pattern BP and first and second impurity regions IM1(n) and IM2(n) of the left peripheral transistor PTR(L). P-type impurities may be doped in a conductive pattern BP and first and second impurity regions IM1(p) and IM2(p) of the right peripheral transistor PTR(R). The left peripheral transistor PTR(L) may be a VCT structured NMOS transistor. The right peripheral transistor PTR(R) may be a VCT structured PMOS transistor. The pair transistor structure PTS may have a CMOS transistor structure that shares a peripheral gate electrode GE.

Each of the left peripheral transistor PTR(L) and the right peripheral transistor PTR(R) may include a peripheral active pattern PAP. The peripheral gate electrode GE may be interposed between the first and second peripheral active patterns PAP(1) and PAP(2) that are adjacent to each other. A first peripheral back gate electrode BG1 may be disposed on a left side of the first peripheral active pattern PAP(1). A second peripheral back gate electrode BG2 may be disposed on a right side of the second peripheral active pattern PAP(2). The left peripheral transistor PTR(L) and the right peripheral transistor PTR(R) may share the peripheral gate electrode GE. A threshold voltage of the left peripheral transistor PTR(L) may be adjusted by the first peripheral back gate electrode BG1. A threshold voltage of the right peripheral transistor PTR(R) may be adjusted by the second peripheral back gate electrode BG2.

Referring to FIGS. 18A and 18C, an input voltage Vin may be applied to the peripheral gate electrode GE. The second impurity region IM2 of the left peripheral transistor PTR(L) may be electrically grounded. A power voltage Vdd may be applied to the second impurity region IM2 of the right peripheral transistor PTR(R). A first back gate voltage Vbgn may be applied to the first peripheral back gate electrode BG1, and a second back gate voltage Vbgp may be applied to the second peripheral back gate electrode BG2. The first impurity regions IM1 of the left peripheral transistor PTR(L) and the right peripheral transistor PTR(R) may be connected through a first source/drain connection line SDL1, and through this configuration, an output voltage Vout may be readout. A semiconductor device of FIG. 18A having a circuit of FIG. 18C may correspond to an inverter that shares a gate electrode. For example, when the input voltage Vin has a high level, the output voltage Vout has a low level. In a case where the input voltage Vin has a low level, the output voltage Vout has a high level.

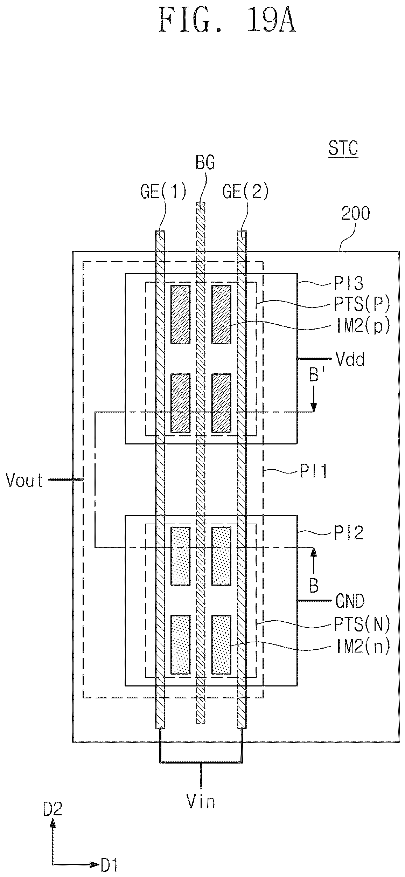

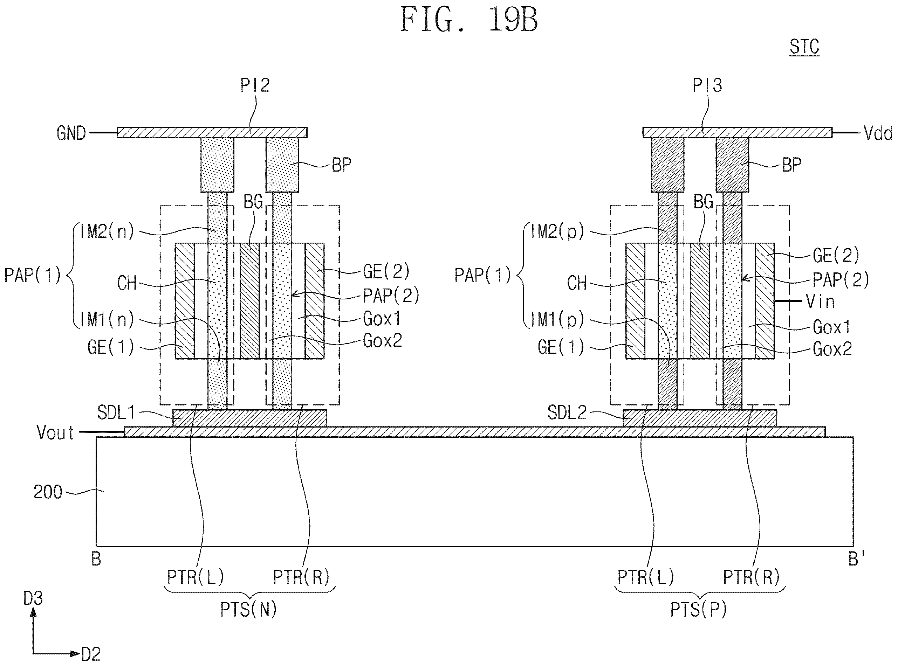

FIG. 19A illustrates a plan view showing a semiconductor device according to some embodiments of the present inventive concepts. FIG. 19B illustrates a cross-sectional view taken along line B-B' of FIG. 19A.

Referring to FIGS. 19A and 19B, a semiconductor device according to the present embodiment may correspond to an example of a standard cell STC of a logic circuit. A first peripheral wiring line PI1 may be disposed on the lower structure 200. The first peripheral wiring line PI1 may be provided thereon with a first source/drain connection line SDL 1 and a second source/drain connection line SDL2 that are spaced apart from each other in a second direction D2. An N-type pair transistor structure PTS(N) may be disposed on the first source/drain connection line SDL1. A P-type pair transistor structure PTS(P) may be disposed on the second source/drain connection line SDL2. A first peripheral gate electrode GE(1) of the N-type pair transistor structure PTS(N) may extend in the second direction D2 to serve as a first peripheral gate electrode GE(1) of the P-type pair transistor structure PTS(P). A second peripheral gate electrode GE(2) of the N-type pair transistor structure PTS(N) may extend in the second direction D2 to serve as a second peripheral gate electrode GE(2) of the P-type pair transistor structure PTS(P). A peripheral back gate electrode BG of the N-type pair transistor structure PTS(N) may extend in the second direction D2 to become a peripheral back gate electrode BG of the P-type pair transistor structure PTS(P). A second peripheral wiring line PI2 may be disposed on the N-type pair transistor structure PTS(N). A third peripheral wiring line PI3 may be disposed on the P-type pair transistor structure PTS(P).

A ground voltage GND may be applied to the second peripheral wiring line PI2. A power voltage Vdd may be applied to the third peripheral wiring line PI3. An input voltage Vin may be applied to the first peripheral gate electrode GE(1) and the second peripheral gate electrode GE(2). The power voltage Vdd may be readout through the first peripheral wiring line PI1.

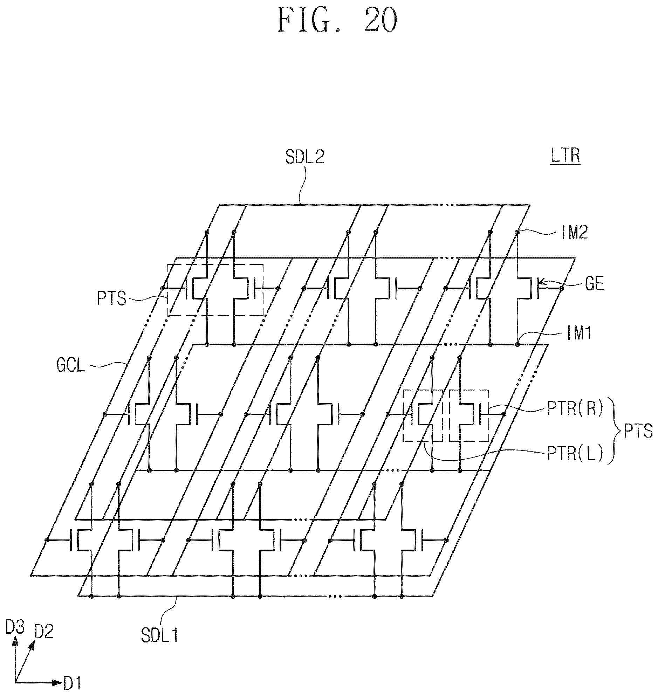

FIG. 20 illustrates a circuit diagram showing a logic transistor according to some embodiments of the present inventive concepts.

Referring to FIG. 20, a logic transistor LTR according to the present embodiment may include pair transistor structures PTS arranged in M rows and N columns that are connected with each other and two-dimensionally arranged along a first direction D1 and a second direction D2. The M and N may each be a natural number of equal to or greater than 2. Each of the pair transistor structures PTS may include a pair of left and right peripheral transistors PTR(L) and PTR(R) that are adjacent to each other as discussed with reference to FIGS. 13A to 18C. Each of the left peripheral transistor PTR(L) and the right peripheral transistor PTR(R) may be called a unit transistor.

A first source/drain connection line SDL1 may connect first impurity regions IM1 of each of the pair transistor structures PTS with each other. A second source/drain connection line SDL2 may connect second impurity regions IM2 of each of the pair transistor structures PTS with each other. A gate connection line GCL may connect peripheral gate electrodes GE of each of the pair transistor structures PTS with each other.

An output value of the logic transistor LTR according to the present inventive concepts may be the same as a sum of output values of the unit transistors. As the logic transistor LTR is formed of a plurality of unit transistors each having a VCT structure.

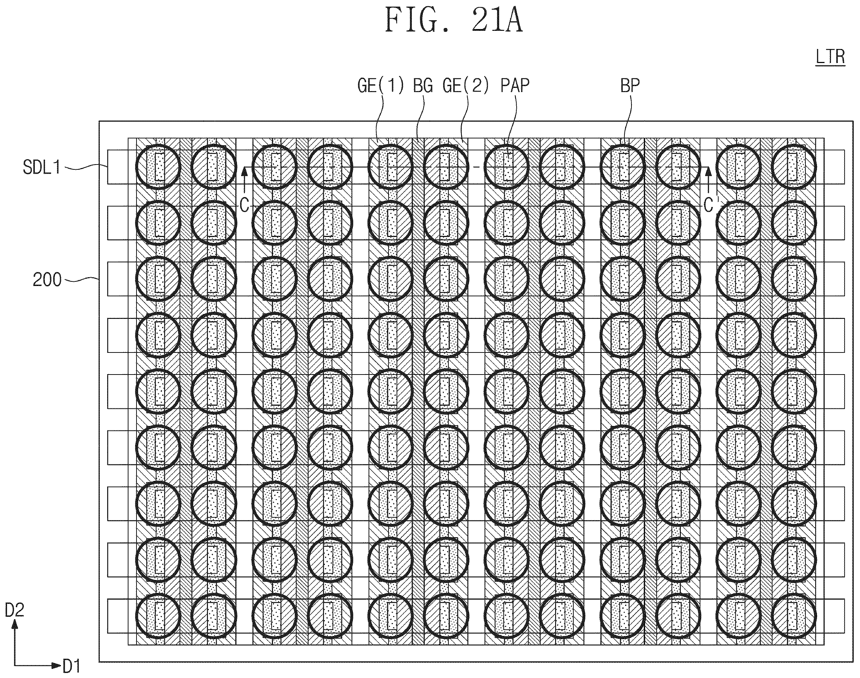

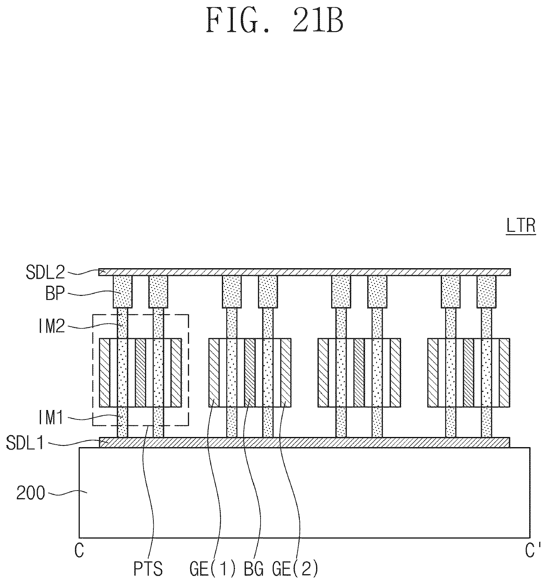

FIG. 21A illustrates a plan view showing a logic transistor according to some embodiments of the present inventive concepts. FIG. 21B illustrates a cross-sectional view taken along line C-C' of FIG. 21A.

Referring to FIGS. 21A and 21B, a logic transistor LTR according to the present embodiment may have a circuit discussed with reference to FIG. 20. The logic transistor LTR may include a plurality of pair transistor structures PTS on the lower structure 200 that are two-dimensionally arranged along a first direction D1 and a second direction D2. The first source/drain connection lines SDL1 that connect the first impurity regions IM1 of the pair transistor structures PTS with each other may have a linear shape that extends along the first direction D1 and may be spaced apart from each other in the second direction D2. On each of the pair transistor structures PTS, first peripheral gate electrodes GE(1), peripheral back gate electrodes BG, and second peripheral gate electrodes GE(2) may each have a linear shape that extends along the second direction D2 and may be spaced apart from each other in the first direction D1. Peripheral active patterns PAP may have island shapes that are two-dimensionally arranged along the first and second directions D1 and D2 and are spaced apart from each other. Conductive patterns BP may correspondingly overlap the peripheral active patterns PAP. The conductive patterns BP may have island shapes that are two-dimensionally arranged along the first and second directions D1 and D2 and are spaced apart from each other. The second source/drain connection lines SDL2 may connect the conductive patterns BP with each other. Other configurations may be identical or similar to those discussed above.

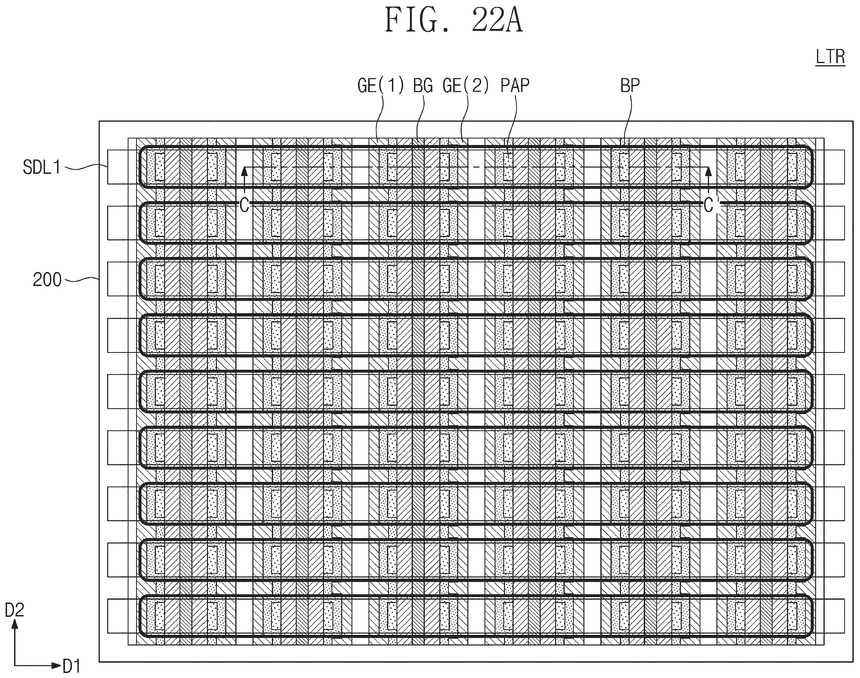

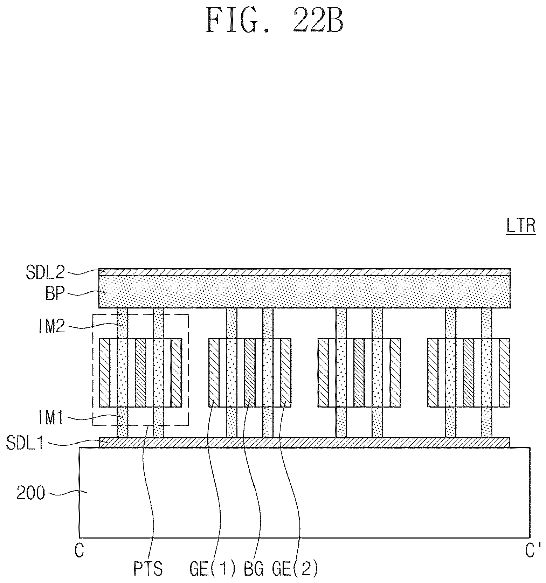

FIG. 22A illustrates a plan view showing a logic transistor according to some embodiments of the present inventive concepts. FIG. 22B illustrates a cross-sectional view taken along line C-C' of FIG. 22A.

Referring to FIGS. 22A and 22B, in a logic transistor LTR according to the present embodiment, the conductive patterns BP may have linear shapes that extend along the first direction D1 and may be spaced apart from each other in the second direction D2. Other configurations may be identical or similar to those discussed with reference to FIGS. 21A and 21B.

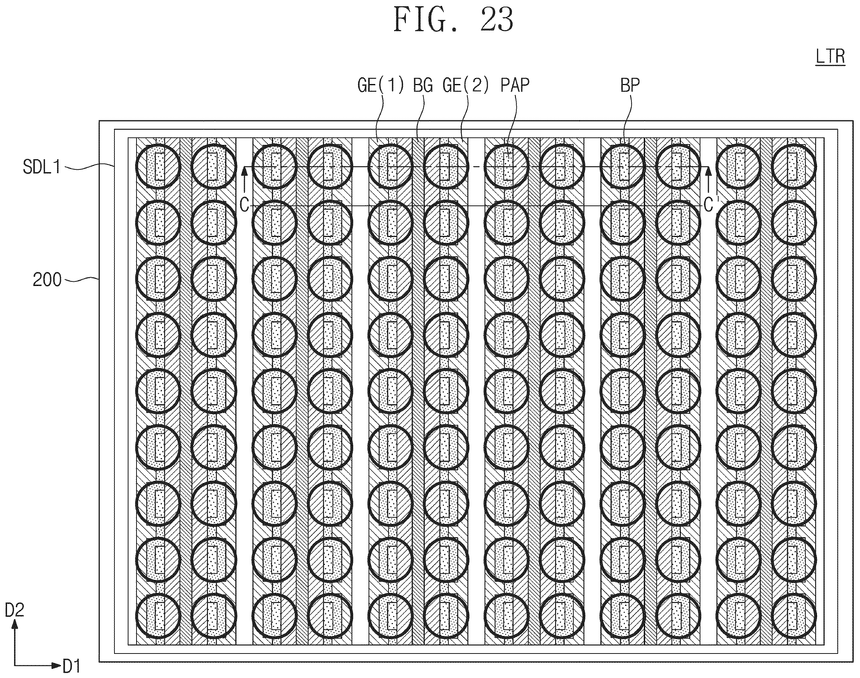

FIG. 23 illustrates a plan view showing a logic transistor according to some embodiments of the present inventive concepts. A cross-section obtained by cutting FIG. 23 along line C-C' may correspond to FIG. 21B.

Referring to FIG. 23, the first source/drain connection lines SDL1 may be connected with each other to have a plate shape. Other configurations may be identical or similar to those discussed with reference to FIGS. 21A and 21B.

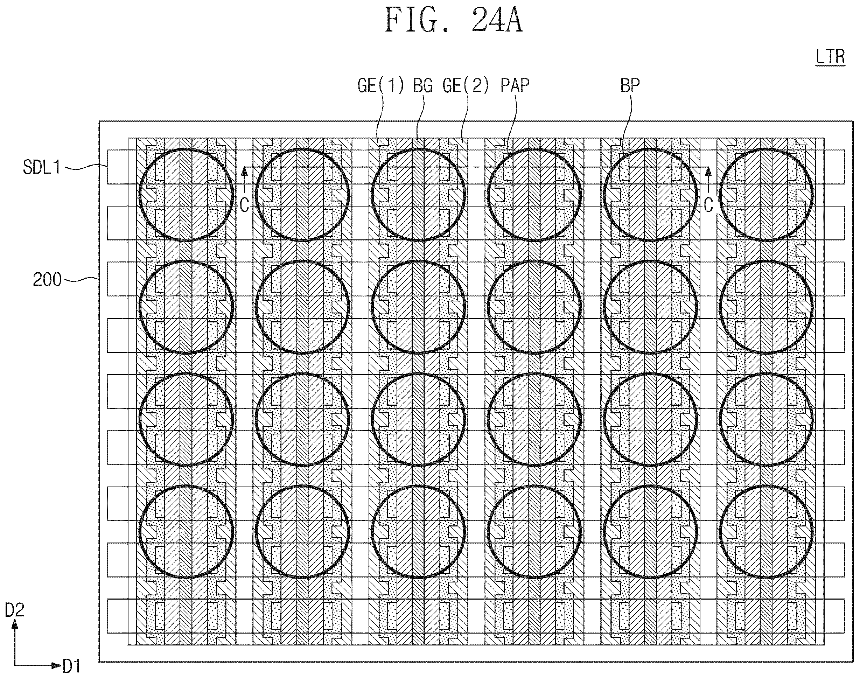

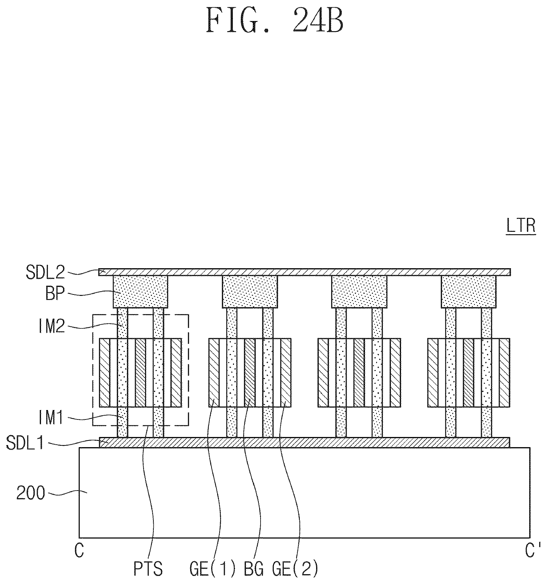

FIG. 24A illustrates a plan view showing a logic transistor according to some embodiments of the present inventive concepts. FIG. 24B illustrates a cross-sectional view taken along line C-C' of FIG. 24A.

Referring to FIGS. 24A and 24B, one conductive pattern BP may overlap four neighboring peripheral active patterns PAP. The conductive pattern BP may be provided in plural, and the plurality of conductive patterns BP may have island shapes that are two-dimensionally arranged in the first and second directions D1 and D2 and are spaced apart from each other. Other configurations may be identical or similar to those discussed with reference to FIGS. 21A and 21B.

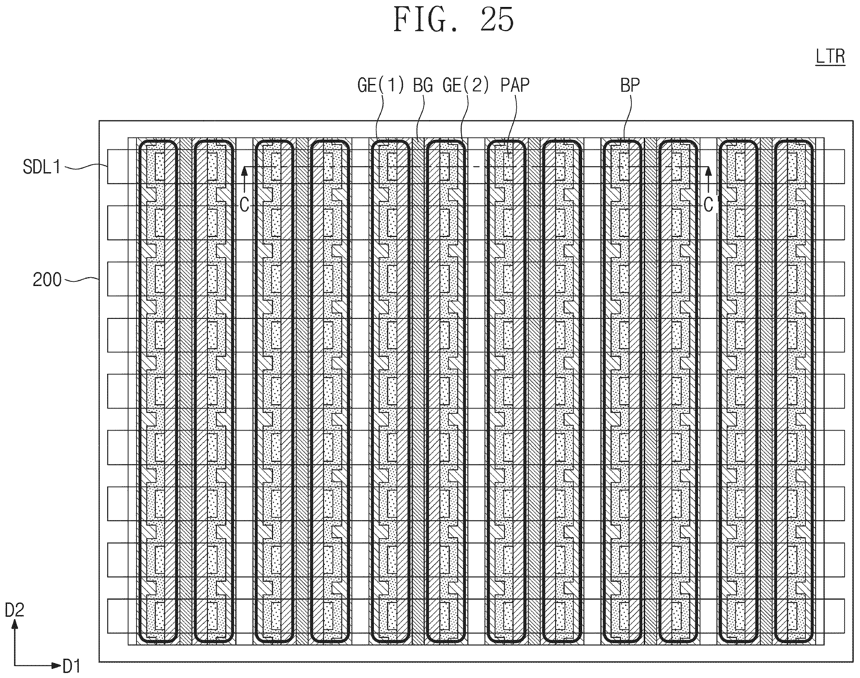

FIG. 25 illustrates a plan view showing a logic transistor according to some embodiments of the present inventive concepts. A cross-section obtained by cutting FIG. 25 along line C-C' may correspond to FIG. 21B.

Referring to FIG. 25, the conductive patterns BP of FIG. 23 may extend in the second direction D2 to be connected with each other, thereby having a linear shape extending in the second direction D2. The conductive patterns BP may be spaced apart from each other in the first direction D1. Other configurations may be identical or similar to those discussed with reference to FIGS. 21A and 21B.

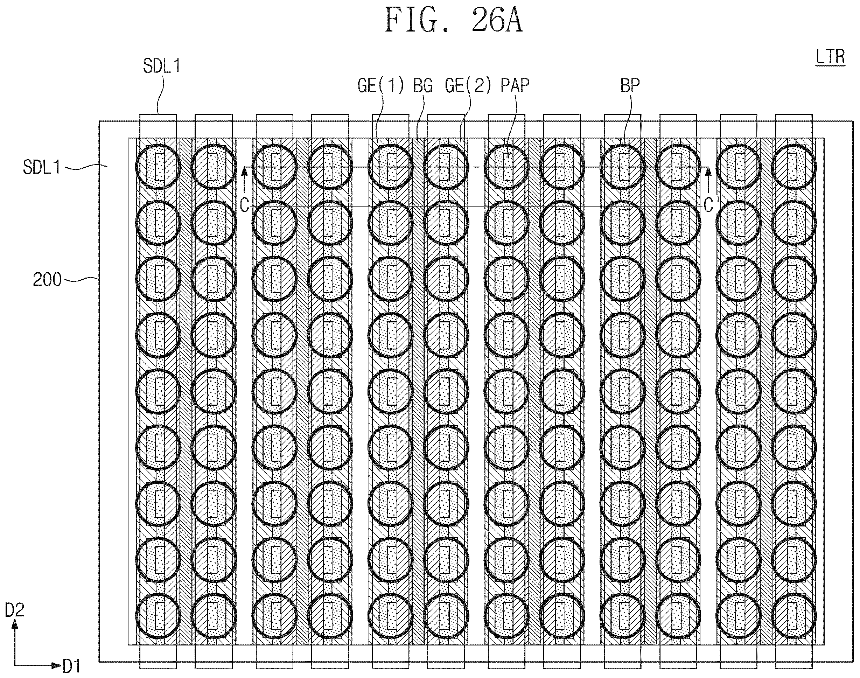

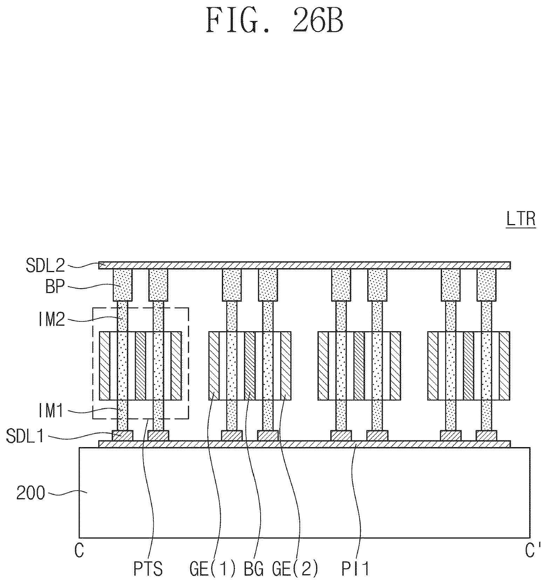

FIG. 26A illustrates a plan view showing a logic transistor according to some embodiments of the present inventive concepts. FIG. 26B illustrates a cross-sectional view taken along line C-C' of FIG. 26A.

Referring to FIGS. 26A and 26B, the first source/drain connection lines SDL1 may have a linear shape that extends in the second direction D2 and may be spaced apart from each other in the first direction D1. Other configurations may be identical or similar to those discussed with reference to FIGS. 21A and 21B.

The logic transistor LTR of FIGS. 20 to 26B may correspond to at least one of the first to third peripheral transistors PTR1 to PTR3 discussed with reference to FIGS. 2 to 11.

A semiconductor device according to the present inventive concepts may include a cell structure and a peripheral structure that are stacked, and peripheral transistors included in the cell structure and/or the peripheral structure may have a vertical channel transistor (VCT) structure. In addition, a logic transistor may be formed of VCT structured unit transistors. It may thus be possible to reduce a horizontal area of the peripheral structure, to decrease a connection distance between the cell structure and the peripheral structure, and to facilitate wiring routing. Moreover, no through via may be included, and thus the semiconductor device may have a reduced horizontal size. Accordingly, the semiconductor device may become highly integrated.

## Claims

1. A memory device comprising:
a cell structure (CS); and
a peripheral structure (PS) disposed on the cell structure (CS),
wherein the cell structure (CS) includes a first memory block (BLK(1)) and a second memory block (BLK(2)) that are side by side in a first horizontal direction,
wherein the peripheral structure (PS) includes:
a first core circuit section (Core(1)) on the first memory block (BLK(1)); and
a second core circuit section (Core(2)) on the second memory block (BLK(2)),
wherein each of the first and second memory blocks (BLK(1), BLK(2)) includes a plurality of cell transistors (CTR),
wherein each of the plurality of first and second core circuit sections (Core(1), Core(2)) includes a plurality of first peripheral transistors (PTR1),
wherein each of the first peripheral transistors (PTR1) includes:
a first peripheral active pattern (PAP(1)) extending in a second horizontal direction perpendicular to the first horizontal direction;
a first peripheral gate electrode (GE(1)) adjacent to one sidewall of the first peripheral active pattern (PAP(1)), **characterised in that** each of the first peripheral transistors (PTR1) further comprises:
a first peripheral impurity region (IM1) and a second peripheral impurity region (IM2) on a lower portion and an upper portion of the first peripheral active pattern (PAP(1)), respectively, and
wherein, in each of the plurality of first peripheral transistors (PTR1), the first and second peripheral impurity regions (IM1, IM2) are spaced apart from each other in a third direction perpendicular to the first and second horizontal directions.

2. The memory device of claim 1,
wherein the peripheral structure (PS) further includes a first peripheral circuit section (PE(1)) between the first core circuit section (Core(1)) and the second core circuit section (Core(2)),
wherein the first peripheral circuit section (PE(1)) includes a plurality of second peripheral transistors (PTR2), and
wherein each of the second peripheral transistors (PTR2) includes:
a second peripheral active pattern (PAP(2)) extending in the second horizontal direction; and
a second peripheral gate electrode (GE(2)) adjacent to one sidewall of the second peripheral active pattern (PAP(2)).

3. The memory device of claim 2,
wherein the cell structure (CS) further includes a second peripheral circuit section (PE(2)) between the first memory block (BLK(1)) and the second memory block (BLK(2)),
wherein the second peripheral circuit section (PE(2)) includes a plurality of third peripheral transistors (PTR3), and
wherein each of the third peripheral transistors (PTR3) includes:
a third peripheral active pattern (PAP) extending in the second horizontal direction; and
a third peripheral gate electrode (GE) adjacent to one sidewall of the third peripheral active pattern.

4. The memory device of claim 3,
wherein each of the first and second memory blocks (BLK(1), BLK(2)) further includes a plurality of cell capacitors (CAP1) that are connected to the plurality of cell transistors (CTR), respectively,
wherein the second peripheral circuit section (PE(2)) further includes a peripheral capacitor (CAP2) connected to one of the third peripheral transistors (PTR3), and
wherein the peripheral capacitor (CAP2) includes:
a plurality of bottom electrodes (BE),
an electrode pad (EP) that connects the bottom electrodes (BE) with each other,
a dielectric layer (DL) covering the electrode pad (EP) and each of the plurality of bottom electrodes (BE), and
a top electrode (UE) on the dielectric layer (DL).

5. The memory device of claim 3,
wherein the second peripheral circuit section (PE(2)) further includes a backside power delivery network layer (PDN).

6. The memory device of claim **1,**
wherein each of the cell transistors (CTR) includes:
a cell active pattern (AP) extending in the second horizontal direction;
a word line (WL) adjacent to a lateral surface of the cell active pattern (AP); and
a first cell impurity region (IM1) and a second cell impurity region (IM2) on a lower portion and an upper portion of the cell active pattern (AP), respectively,
wherein, in each of the cell transistors (CTR), the first and second cell impurity regions (IM1, IM2) are spaced apart from each other in the third direction perpendicular to the first and second horizontal directions, and
wherein a conductivity type of impurities doped in the first and second cell impurity regions (IM1, IM2) is different from a conductivity type of impurities doped in the first and second peripheral impurity regions (IM1, IM2).

7. The memory device of claim 1,
wherein each of the cell transistors (CTR) includes:
a cell active pattern (AP) extending in the second horizontal direction;
a word line (WL) adjacent to a lateral surface of the cell active pattern (AP); and
a first cell impurity region (IM1) and a second cell impurity region (IM2) on a lower portion and an upper portion of the cell active pattern (AP), respectively,
wherein, in each of the cell transistors (CTR), the first and second cell impurity regions (IM1, IM2) are spaced apart from each other in the third direction perpendicular to the first and second horizontal directions,
wherein first impurities are doped in the first and second cell impurity regions (IM1, IM2) and the first and second peripheral impurity regions (IM1, IM2), and
wherein a concentration of the first impurities doped in the first and second cell impurity regions (IM1, IM2) is less than a concentration of the first impurities doped in the first and second peripheral impurity regions (IM1, IM2).

8. The memory device of claim 1,
wherein at least one of the first and second core circuit sections (Core(1), Core(2)) further includes:
a first wiring line (PI1) that connects first peripheral impurity regions (IM1) of some of the plurality of first peripheral transistors (PTR1) with each other;
a second wiring line (PI2) that connects second peripheral impurity regions (IM2) of the some of the plurality of first peripheral transistors (PTR1) with each other; and
a third wiring line (PI3) that connects first peripheral gate electrodes (GE(1)) of the some of the first peripheral transistors (PTR1) with each other.

9. The memory device of claim 8,
wherein at least one of the first and second core circuit sections (Core(1), Core(2)) further includes:
a plurality of first conductive patterns (BP) between the first wiring line (PI1) and the first peripheral impurity regions (IM1) of the some of the first peripheral transistors (PTR1); and
a plurality of second conductive patterns (BP) between the second wiring line (PI2) and the second peripheral impurity regions (IM2) of the some of the first peripheral transistors (PTR1), and
wherein, when viewed in a plan view, each of the first and second conductive patterns (BP) has a linear shape or a plate shape.

10. The memory device of claim 1,
wherein a pair of neighboring ones of the first peripheral transistors (PTR1) constitute a pair transistor structure (PTS),
wherein the pair transistor structure (PTS) includes a left peripheral transistor (PTR(L)) and a right peripheral transistor (PTR(R)) that are adjacent to and are symmetric with each other in configuration, each of the left and right peripheral transistors (PTR(R)) including the first peripheral active pattern (PAP(1)), the first peripheral gate electrode (GE(1)), and the first and second peripheral impurity regions (IM1, IM2),
wherein the first and second peripheral impurity regions (IM1, IM2) of the left peripheral transistor (PTR(L)) are doped with N-type impurities, and
wherein the first and second peripheral impurity regions (IM1, IM2) of the right peripheral transistor (PTR(R)) are doped with P-type impurities.

11. The memory device of claim 10,
wherein the pair transistor structure (PTS) further includes a second peripheral gate electrode (GE(2)) between the first peripheral active pattern (PAP(1)) of the left peripheral transistor (PTR(L)) and the first peripheral active pattern (PAP(1)) of the right peripheral transistor (PTR(R)).

12. The memory device of claim 11,
wherein a first peripheral gate electrode (GE(1)) of the left peripheral transistor (PTR(L)), a first peripheral gate electrode (GE(1)) of the right peripheral transistor (PTR(R)), and the second peripheral gate electrode (GE(2)) are provided with voltages that are different from each other.

13. The memory device of claim 1,
wherein the cell structure (CS) includes a plurality of cell connection pads (CP2) on a top end of the cell structure (CS), and
wherein the peripheral structure (PS) includes a plurality of peripheral connection pads (CP1) on a bottom end of the peripheral structure (PS), the peripheral connection pads (CP1) contacting the cell connection pads (CP2), respectively.

14. The memory device of claim 1,
wherein the cell structure (CS) further includes a cell interlayer dielectric layer (IL) on a top end of the cell structure (CS), and
wherein the peripheral structure (PS) further includes:
a peripheral interlayer dielectric layer (PL) on a bottom end of the peripheral structure (PS) and contacting the cell interlayer dielectric layer (IL); and
a contact plug that penetrates the peripheral interlayer dielectric layer (PL) and the cell interlayer dielectric layer (IL) to connect one of the first peripheral transistors (PTR1) to one of the plurality of cell transistors (CTR).

## Patentansprüche

1. Speichervorrichtung, aufweisend:
eine Zellstruktur (CS); und
eine auf der Zellstruktur (CS) angeordnete Peripheriestruktur (PS),
wobei die Zellstruktur (CS) einen ersten Speicherblock (BLK(1)) und einen zweiten Speicherblock (BLK(2)) umfasst, die in einer ersten horizontalen Richtung nebeneinander angeordnet sind,
wobei die Peripheriestruktur (PS) umfasst:
einen ersten Kernschaltungsbereich (Core(1)) auf dem ersten Speicherblock (BLK(1)); und
einen zweiten Kernschaltungsbereich (Core(2)) auf dem zweiten Speicherblock (BLK(2)), wobei jeweils die ersten und die zweiten Speicherblöcke (BLK(1), BLK(2)) eine Vielzahl von Zelltransistoren (CTR) umfassen,
wobei jeder von der Vielzahl von ersten und zweiten Kernschaltungsbereichen (Core(1), Core(2)) eine Vielzahl von ersten Peripherietransistoren (PTR1) umfasst,
wobei jeder von den ersten Peripherietransistoren (PTR1) umfasst:
ein erstes peripheres aktives Muster (PAP(1)), das sich in einer zweiten horizontalen Richtung senkrecht zu der ersten horizontalen Richtung erstreckt;
eine erste periphere Gate-Elektrode (GE(1)), die an eine Seitenwand des ersten peripheren aktiven Musters (PAP(1)) angrenzt, **dadurch gekennzeichnet, dass** jeder der ersten Peripherietransistoren (PTR1) ferner aufweist:
eine erste periphere Dotierungsregion (IM1) und eine zweite periphere Dotierungsregion (IM2) auf jeweils einem unteren Abschnitt und einem oberen Abschnitt des ersten peripheren aktiven Musters (PAP(1)), und
wobei in jedem von der Vielzahl von ersten Peripherietransistoren (PTR1) die ersten und die zweiten peripheren Dotierungsregionen (IM1, IM2) in einer dritten Richtung senkrecht zur ersten und zweiten horizontalen Richtung voneinander beabstandet sind.

2. Speichervorrichtung nach Anspruch 1,
wobei die Peripheriestruktur (PS) ferner einen ersten Peripherieschaltungsbereich (PE(1)) zwischen dem ersten Kernschaltungsbereich (Core(1)) und dem zweiten Kernschaltungsbereich (Core(2)) umfasst,
wobei der erste Peripherieschaltungsbereich (PE(1)) eine Vielzahl von zweiten Peripherietransistoren (PTR2) umfasst, und
wobei jeder von den zweiten Peripherietransistoren (PTR2) umfasst:
ein zweites peripheres aktives Muster (PAP(2)), das sich in der zweiten horizontalen Richtung erstreckt; und
eine zweite periphere Gate-Elektrode (GE(2)), die an eine Seitenwand des zweiten peripheren aktiven Musters (PAP(2)) angrenzt.

3. Speichervorrichtung nach Anspruch 2,
wobei die Zellstruktur (CS) ferner einen zweiten Peripherieschaltungsbereich (PE(2)) zwischen dem ersten Speicherblock (BLK(1)) und dem zweiten Speicherblock (BLK(2)) umfasst,
wobei der zweite Peripherieschaltungsbereich (PE(2)) eine Vielzahl von dritten Peripherietransistoren (PTR3) umfasst, und
wobei jeder von den dritten Peripherietransistoren (PTR3) umfasst:
ein drittes peripheres aktives Muster (PAP), das sich in der zweiten horizontalen Richtung erstreckt; und
eine dritte periphere Gate-Elektrode (GE), die an eine Seitenwand des dritten peripheren aktiven Musters angrenzt.

4. Speichervorrichtung nach Anspruch 3,
wobei jeweils die ersten und zweiten Speicherblöcke (BLK(1), BLK(2)) ferner eine Vielzahl von Zellkondensatoren (CAP1) umfassen, die jeweils mit der Vielzahl von Zelltransistoren (CTR) verbunden sind,
wobei der zweite Peripherieschaltungsbereich (PE(2)) ferner einen Peripheriekondensator (CAP2) umfasst, der mit einem der dritten Peripherietransistoren (PTR3) verbunden ist, und
wobei der Peripheriekondensator (CAP2) umfasst:
eine Vielzahl von unteren Elektroden (BE),
ein Elektrodenpad (EP), das die unteren Elektroden (BE) miteinander verbindet,
eine dielektrische Schicht (DL), die das Elektrodenpad (EP) und jede der Vielzahl von unteren Elektroden (BE) bedeckt, und
eine obere Elektrode (UE) auf der dielektrischen Schicht (DL).

5. Speichervorrichtung nach Anspruch 3,
wobei der zweite Peripherieschaltungsbereich (PE(2)) ferner eine rückseitige Leistungszuführungsnetzwerkschicht (PDN) umfasst.

6. Speichervorrichtung nach Anspruch 1,
wobei jeder der Zelltransistoren (CTR) umfasst:
ein sich in der zweiten horizontalen Richtung erstreckendes aktives Zellmuster (AP);
eine Wortleitung (WL), die an eine Seitenfläche des aktiven Zellmusters (AP) angrenzt; und
eine erste Zelldotierungsregion (IM1) und eine zweite Zelldotierungsregion (IM2) jeweils an einem unteren Abschnitt und einem oberen Abschnitt des aktiven Zellmusters (AP),
wobei in jedem der Zelltransistoren (CTR) die ersten und zweiten Zelldotierungsregionen (IM1, IM2) in der dritten Richtung, die senkrecht zu den ersten und zweiten horizontalen Richtungen verläuft, voneinander beabstandet sind, und wobei sich ein Leitfähigkeitstyp von in den ersten und zweiten Zelldotierungsregionen (IM1, IM2) dotierten Verunreinigungen von einem Leitfähigkeitstyp von in den ersten und zweiten peripheren Dotierungsregionen (IM1, IM2) dotierten Verunreinigungen unterscheidet.

7. Speichervorrichtung nach Anspruch 1,
wobei jeder von den Zelltransistoren (CTR) umfasst:
ein sich in der zweiten horizontalen Richtung erstreckendes aktives Zellmuster (AP);
eine Wortleitung (WL), die an eine seitliche Oberfläche des aktiven Zellmusters (AP) angrenzt; und
eine erste Zelldotierungsregion (IM1) und eine zweite Zelldotierungsregion (IM2) jeweils an einem unteren Abschnitt und einem oberen Abschnitt des aktiven Zellmusters (AP),
wobei in jedem der Zelltransistoren (CTR) die ersten und zweiten Zelldotierungsregionen (IM1, IM2) in der dritten Richtung, die senkrecht zu den ersten und zweiten horizontalen Richtungen verläuft, voneinander beabstandet sind, wobei erste Verunreinigungen in den ersten und zweiten Zelldotierungsregionen (IM1, IM2) sowie in den ersten und zweiten peripheren Dotierungsregionen (IM1, IM2) dotiert sind, und
wobei eine Konzentration der ersten Verunreinigungen, die in den ersten und zweiten Zelldotierungsregionen (IM1, IM2) dotiert sind, geringer ist als eine Konzentration der ersten Verunreinigungen, die in den ersten und zweiten peripheren Dotierungsregionen (IM1, IM2) dotiert sind.

8. Speichervorrichtung nach Anspruch 1,
wobei mindestens einer von den ersten und zweiten Kernschaltungsbereichen (Core(1), Core(2)) ferner umfasst:
eine erste Verdrahtungsleitung (PI1), die erste periphere Dotierungsregionen (IM1) von einigen von der Vielzahl von ersten Peripherietransistoren (PTR1) miteinander verbindet;
eine zweite Verdrahtungsleitung (PI2), die zweite periphere Dotierungsregionen (IM2) von einigen von der Vielzahl von ersten Peripherietransistoren (PTR1) miteinander verbindet; und
eine dritte Verdrahtungsleitung (PI3), die erste periphere Gate-Elektroden (GE(1)) von einigen von den ersten Peripherietransistoren (PTR1) miteinander verbindet.

9. Speichervorrichtung nach Anspruch 8,
wobei mindestens einer von den ersten und zweiten Kernschaltungsbereichen (Core(1), Core(2)) ferner umfasst:
eine Vielzahl von ersten leitfähigen Mustern (BP) zwischen der ersten Verdrahtungsleitung (PI1) und den ersten peripheren Dotierungsregionen (IM1) von einigen von den ersten Peripherietransistoren (PTR1); sowie
eine Vielzahl von zweiten leitfähigen Mustern (BP) zwischen der zweiten Verdrahtungsleitung (PI2) und den zweiten peripheren Dotierungsregionen (IM2) von einigen von den ersten Peripherietransistoren (PTR1), und
wobei, in einer Draufsicht betrachtet, jedes der ersten und zweiten leitfähigen Muster (BP) eine lineare Form oder eine plattenförmige Form aufweist.

10. Speichervorrichtung nach Anspruch 1,
wobei ein Paar von benachbarten ersten Peripherietransistoren (PTR1) eine Paartransistorstruktur (PTS) bilden,
wobei die Paartransistorstruktur (PTS) einen linken Peripherietransistor (PTR(L)) und einen rechten Peripherietransistor (PTR(R)) umfasst, die aneinander angrenzen und in ihrer Konfiguration symmetrisch zueinander sind, wobei jeweils die linken und rechten Peripherietransistoren (PTR(R)) das erste periphere aktive Muster (PAP(1)), die erste periphere Gate-Elektrode (GE(1)) sowie die ersten und zweiten peripheren Dotierungsregionen (IM1, IM2) umfassen,
wobei die ersten und zweiten peripheren Dotierungsregionen (IM1, IM2) des linken Peripherietransistors (PTR(L)) mit N-Typ-Dotierungen dotiert sind, und
wobei die ersten und zweiten peripheren Dotierungsregionen (IM1, IM2) des rechten Peripherietransistors (PTR(R)) mit P-Typ-Dotierungen dotiert sind.

11. Speichervorrichtung nach Anspruch 10,
wobei die Paartransistorstruktur (PTS) ferner eine zweite periphere Gate-Elektrode (GE(2)) zwischen dem ersten peripheren aktiven Muster (PAP(1)) des linken Peripherietransistors (PTR(L)) und dem ersten peripheren aktiven Muster (PAP(1)) des rechten Peripherietransistors (PTR(R)) umfasst.

12. Speichervorrichtung nach Anspruch 11,
wobei eine erste periphere Gate-Elektrode (GE(1)) des linken Peripherietransistors (PTR(L)), eine erste periphere Gate-Elektrode (GE(1)) des rechten Peripherietransistors (PTR(R)) und die zweite periphere Gate-Elektrode (GE(2)) mit Spannungen versorgt werden, die sich voneinander unterscheiden.

13. Speichervorrichtung nach Anspruch 1,
wobei die Zellstruktur (CS) eine Vielzahl von Zellverbindungspads (CP2) an einem oberen Ende der Zellstruktur (CS) umfasst, und
wobei die Peripheriestruktur (PS) eine Vielzahl von Peripherieverbindungspads (CP1) an einem unteren Ende der Peripheriestruktur (PS) umfasst, wobei die Peripherieverbindungspads (CP1) jeweils die Zellverbindungspads (CP2) kontaktieren.

14. Speichervorrichtung nach Anspruch 1,
wobei die Zellstruktur (CS) ferner eine Zellzwischenschicht-Dielektrikumsschicht (IL) an einem oberen Ende der Zellstruktur (CS) umfasst, und
wobei die Peripheriestruktur (PS) ferner umfasst:
eine periphere Zwischenschicht-Dielektrikumsschicht (PL) an einem unteren Ende der Peripheriestruktur (PS), die mit der Zellzwischenschicht-Dielektrikumsschicht (IL) in Kontakt steht; und
ein Kontaktpad, das die periphere Zwischenschicht-Dielektrikumsschicht (PL) und die Zellzwischenschicht-Dielektrikumsschicht (IL) durchdringt, um einen von den ersten Peripherietransistoren (PTR1) mit einem von der Vielzahl von Zelltransistoren (CTR) zu verbinden.

## Revendications

1. Un dispositif de mémoire comprenant :
une structure de cellules (CS) ; et
une structure périphérique (PS) disposée sur la structure de cellules (CS),
dans lequel la structure de cellules (CS) comprend un premier bloc de mémoire (BLK(1)) et un deuxième bloc de mémoire (BLK(2)) qui sont disposés côte à côte dans une première direction horizontale,
dans lequel la structure périphérique (PS) comprend :
une première section de circuit central (Core(1)) sur le premier bloc de mémoire (BLK(1)) ; et
une deuxième section de circuit central (Core(2)) sur le deuxième bloc de mémoire (BLK(2)),
dans lequel chacun des premier et deuxième blocs de mémoire (BLK(1), BLK(2)) comprend une pluralité de transistors de cellule (CTR),
chacune des première et deuxième sections de circuit central (Core(1), Core(2)) comprend une pluralité de premiers transistors périphériques (PTR1),
chacun desdits premiers transistors périphériques (PTR1) comprenant :
un premier motif actif périphérique (PAP(1)) s'étendant dans une deuxième direction horizontale perpendiculaire à la première direction horizontale ;
une première électrode de grille périphérique (GE(1)) adjacente à une paroi latérale du premier motif actif périphérique (PAP(1)), **caractérisé en ce que** chacun des premiers transistors périphériques (PTR1) comprend en outre :
une première région d'impureté périphérique (IM1) et une deuxième région d'impureté périphérique (IM2) situées respectivement sur une partie inférieure et une partie supérieure du premier motif actif périphérique (PAP(1)), et
dans lequel, dans chacun des premiers transistors périphériques (PTR1), les première et deuxième régions d'impuretés périphériques (IM1, IM2) sont espacées l'une de l'autre dans une troisième direction perpendiculaire aux première et deuxième directions horizontales.

2. Le dispositif de mémoire selon la revendication 1,
dans lequel la structure périphérique (PS) comprend en outre une première section de circuit périphérique (PE(1)) située entre la première section de circuit central (Core(1)) et la deuxième section de circuit central (Core(2)),
dans lequel la première section de circuit périphérique (PE(1)) comprend une pluralité de deuxièmes transistors périphériques (PTR2), et
dans lequel chacun des deuxièmes transistors périphériques (PTR2) comprend :
un deuxième motif actif périphérique (PAP(2)) s'étendant dans la seconde direction horizontale ; et
une deuxième électrode de grille périphérique (GE(2)) adjacente à une paroi latérale du deuxième motif actif périphérique (PAP(2)).

3. Le dispositif de mémoire selon la revendication 2,
dans lequel la structure de cellule (CS) comprend en outre une deuxième section de circuit périphérique (PE(2)) située entre le premier bloc de mémoire (BLK(1)) et le deuxième bloc de mémoire (BLK(2)),
dans lequel la deuxième section de circuit périphérique (PE(2)) comprend une pluralité de troisièmes transistors périphériques (PTR3), et
dans lequel chacun des troisièmes transistors périphériques (PTR3) comprend :
un troisième motif actif périphérique (PAP) s'étendant dans la deuxième direction horizontale ; et
une troisième électrode de grille périphérique (GE) adjacente à une paroi latérale du troisième motif actif périphérique.

4. Le dispositif de mémoire selon la revendication 3,
dans lequel chacun des premier et deuxième blocs de mémoire (BLK(1), BLK(2)) comprend en outre une pluralité de condensateurs de cellule (CAP1) qui sont respectivement connectés à la pluralité de transistors de cellule (CTR),
dans lequel la deuxième section de circuit périphérique (PE(2)) comprend en outre un condensateur périphérique (CAP2) connecté à l'un des troisièmes transistors périphériques (PTR3), et
dans lequel le condensateur périphérique (CAP2) comprend :
une pluralité d'électrodes inférieures (BE),
un plot d'électrode (EP) reliant les électrodes inférieures (BE) entre elles,
une couche diélectrique (DL) recouvrant le plot d'électrode (EP) et chacune des électrodes inférieures (BE) de la pluralité, et
une électrode supérieure (UE) située sur la couche diélectrique (DL).

5. Le dispositif de mémoire selon la revendication 3,
dans lequel la deuxième section de circuit périphérique (PE(2)) comprend en outre une couche de réseau de distribution d'énergie à l'arrière (PDN).

6. Le dispositif de mémoire selon la revendication 1,
dans lequel chacun des transistors de cellule (CTR) comprend :
un motif actif de cellule (AP) s'étendant dans la deuxième direction horizontale ;
une ligne de mots (WL) adjacente à une surface latérale du motif actif de cellule (AP) ; et
une première région d'impuretés de cellule (IM1) et une deuxième région d'impuretés de cellule (IM2) situées respectivement sur une partie inférieure et une partie supérieure du motif actif de cellule (AP),
dans lequel, dans chacun des transistors de cellule (CTR), les première et deuxième régions d'impuretés de cellule (IM1, IM2) sont espacées l'une de l'autre dans la troisième direction perpendiculaire aux première et deuxième directions horizontales, et
dans lequel le type de conductivité des impuretés dopées dans les première et deuxième régions d'impuretés de cellule (IM1, IM2) est différent du type de conductivité des impuretés dopées dans les première et deuxième régions d'impuretés périphériques (IM1, IM2).

7. Le dispositif de mémoire selon la revendication 1,
dans lequel chacun des transistors de cellule (CTR) comprend :
un motif actif de cellule (AP) s'étendant dans la deuxième direction horizontale ;
une ligne de mots (WL) adjacente à une surface latérale du motif actif de cellule (AP) ; et
une première région d'impuretés de cellule (IM1) et une deuxième région d'impuretés de cellule (IM2) situées respectivement sur une partie inférieure et une partie supérieure du motif actif de cellule (AP),
dans lequel, dans chacun des transistors de cellule (CTR), les première et deuxième régions d'impuretés de cellule (IM1, IM2) sont espacées l'une de l'autre dans la troisième direction perpendiculaire aux première et deuxième directions horizontales,
dans lequel des premières impuretés sont dopées dans les première et deuxième régions d'impuretés de cellule (IM1, IM2) et dans les première et deuxième régions d'impuretés périphériques (IM1, IM2), et
dans lequel la concentration des premières impuretés dopées dans les première et deuxième régions d'impuretés de cellule (IM1, IM2) est inférieure à la concentration des premières impuretés dopées dans les première et deuxième régions d'impuretés périphériques (IM1, IM2).

8. Le dispositif de mémoire selon la revendication 1,
dans lequel au moins l'une des première et deuxième sections de circuit central (Core(1), Core(2)) comprend en outre :
une première ligne de câblage (PI1) qui relie entre elles les premières régions d'impuretés périphériques (IM1) de certains des premiers transistors périphériques (PTR1) de la pluralité ;
une deuxième ligne de câblage (PI2) qui relie entre elles des deuxièmes régions d'impuretés périphériques (IM2) de certains des premiers transistors périphériques (PTR1) parmi la pluralité de ceux-ci ; et
une troisième ligne de câblage (PI3) qui relie entre elles des premières électrodes de grille périphériques (GE(1)) de certains des premiers transistors périphériques (PTR1) parmi la pluralité de ceux-ci.

9. Le dispositif de mémoire selon la revendication 8,
dans lequel au moins l'une des première et deuxième sections de circuit central (Core(1), Core(2)) comprend en outre :
une pluralité de premiers motifs conducteurs (BP) entre la première ligne de câblage (PI1) et les premières régions d'impuretés périphériques (IM1) de certains des premiers transistors périphériques (PTR1) ; et
une pluralité de seconds motifs conducteurs (BP) entre la seconde ligne de câblage (PI2) et les deuxièmes régions d'impuretés périphériques (IM2) de certains des premiers transistors périphériques (PTR1), et
dans lequel, vu en vue de dessus, chacun des premiers et seconds motifs conducteurs (BP) présente une forme linéaire ou une forme de plaque.

10. Le dispositif de mémoire selon la revendication 1,
dans lequel une paire de transistors périphériques adjacents parmi les premiers transistors périphériques (PTR1) constitue une structure à paire de transistors (PTS),
dans lequel la structure à paire de transistors (PTS) comprend un transistor périphérique gauche (PTR(L)) et un transistor périphérique droit (PTR(R)) qui sont adjacents l'un à l'autre et symétriques l'un par rapport à l'autre en termes de configuration, chacun des transistors périphériques gauche (PTR(L)) et droit (PTR(R)) comprenant le premier motif actif périphérique (PAP(1)), la première électrode de grille périphérique (GE(1)), ainsi que les première et deuxième régions d'impuretés périphériques (IM1, IM2),
dans lequel les première et deuxième régions d'impuretés périphériques (IM1, IM2) du transistor périphérique gauche (PTR(L)) sont dopées avec des impuretés de type N, et
dans lequel les première et deuxième régions d'impuretés périphériques (IM1, IM2) du transistor périphérique droit (PTR(R)) sont dopées avec des impuretés de type P.

11. Le dispositif de mémoire selon la revendication 10,
dans lequel la structure à paires de transistors (PTS) comprend en outre une deuxième électrode de grille périphérique (GE(2)) située entre le premier motif actif périphérique (PAP(1)) du transistor périphérique gauche (PTR(L)) et le premier motif actif périphérique (PAP(1)) du transistor périphérique droit (PTR(R)).

12. Le dispositif de mémoire selon la revendication 11,
dans lequel une première électrode de grille périphérique (GE(1)) du transistor périphérique gauche (PTR(L)), une première électrode de grille périphérique (GE(1)) du transistor périphérique droit (PTR(R)) et la deuxième électrode de grille périphérique (GE(2)) sont alimentées par des tensions différentes les unes des autres.

13. Le dispositif de mémoire selon la revendication 1,
dans lequel la structure de cellule (CS) comprend une pluralité de plots de connexion de cellule (CP2) situés à une extrémité supérieure de la structure de cellule (CS), et
dans lequel la structure périphérique (PS) comprend une pluralité de plots de connexion périphériques (CP1) situés à une extrémité inférieure de la structure périphérique (PS), les plots de connexion périphériques (CP1) étant respectivement en contact avec les plots de connexion de cellule (CP2).

14. Le dispositif de mémoire selon la revendication 1,
dans lequel la structure de cellule (CS) comprend en outre une couche diélectrique intercouche de cellule (IL) située à l'extrémité supérieure de la structure de cellule (CS), et
dans lequel la structure périphérique (PS) comprend en outre :
une couche diélectrique intercouche périphérique (PL) située à l'extrémité inférieure de la structure périphérique (PS) et en contact avec la couche diélectrique intercouche de cellule (IL) ; et
une broche de contact qui traverse la couche diélectrique intercouche périphérique (PL) et la couche diélectrique intercouche de cellule (IL) pour relier l'un des premiers transistors périphériques (PTR1) à l'un des transistors de cellule (CTR) de la pluralité de transistors de cellule.
